# EUROPEAN PATENT SPECIFICATION

(11) **EP 4 415 504 B1**
(45) Date of publication and mention of the grant of the patent: **25.11.2026**
(21) Application number: 24156025.9
(22) Date of filing: 06.02.2024
(51) Int. Cl.: H10K 59/121, H10K 59/123, H10K 59/131, H10K 59/124

(54) **DISPLAY APPARATUS AND METHOD OF MANUFACTURING THE SAME**
ANZEIGEVORRICHTUNG UND VERFAHREN ZUR HERSTELLUNG DAVON
APPAREIL D'AFFICHAGE ET SON PROCÉDÉ DE FABRICATION

(30) Priority: 09.02.2023 KR 20230017256
(43) Date of publication of application: 14.08.2024
(73) Proprietor: Samsung Display Co., Ltd., Yongin-si, Gyeonggi-do 17113 (KR)
(72) Inventor: MOON, Sunggwon, 17113 Yongin-si, Gyeonggi-do (KR); KANG, Donghan, 17113 Yongin-si, Gyeonggi-do (KR); KIM, Jeehoon, 17113 Yongin-si, Gyeonggi-do (KR); SON, Seungsok, 17113 Yongin-si, Gyeonggi-do (KR); YANG, Shinhyuk, 17113 Yongin-si, Gyeonggi-do (KR); LEE, Woogeun, 17113 Yongin-si, Gyeonggi-do (KR)
(74) Representative: Gulde & Partner

(56) References cited:
- KR-A- 20130 005 854
- US-A1- 2019 123 126
- US-A1- 2020 219 952
- US-A1- 2021 175 292
- US-A1- 2021 217 839

## Description

### BACKGROUND

### 1. Field

The present disclosure relates to a display apparatus and a method of manufacturing the same.

### 2. Description of the Related Art

In general, a display apparatus, for example, an organic light-emitting display apparatus, includes a light-emitting diode including a pixel electrode, an emission layer, and an opposite electrode, a transistor electrically connected to the light-emitting diode, and the like. The pixel electrode of the light-emitting diode may receive an electrical signal through the transistor, and the opposite electrode may receive a voltage through a power line. The display apparatus displays images by allowing light emitted from the emission layer of the light-emitting diode to be extracted to the outside. To this end, the display apparatus may include a pad and receive signals from an integrated circuit device and/or a printed circuit board through the pad. For example, US 2021/0175292 A1 discloses A display apparatus including a thin-film encapsulation layer covering pixel on a substrate and including a first inorganic encapsulation layer, an organic encapsulation layer, and a second inorganic encapsulation layer having a different length from that of the first inorganic encapsulation layer, a touch electrode located on the thin-film encapsulation layer, a touch contact line spaced apart from the thin-film encapsulation layer and located outside the thin-film encapsulation layer, an insulating layer located on the touch contact line, a touch contact hole formed in the insulating layer and spaced apart from the thin-film encapsulation layer, and a touch connection line extending from the touch electrode toward the touch contact hole and connected to the touch contact line through the touch contact hole. US 2019/0123126 A1 describes display device including a substrate having a first area, a second area, and a bending portion between the first area and the second area; a first conductive line extending to the first area, the bending portion, and the second area along a first direction on a plane; and a second conductive line comprising a first contact portion and a first connection portion, the first contact portion being connected to the first conductive line at the first area and the first connection portion over-lapping the first conductive line on a plane and extending along the first direction to the first area. the bending portion, and the second area, wherein the second conductive line further comprises a corrosion retardation portion extending from the first contact portion. US 2020/0219952 A1 relates to a display device including a substrate, a display unit disposed over the substrate, and an encapsulation layer sealing the display unit. US 2021/0217839 A1 describes a display apparatus having improved reliability including a substrate; a thin film transistor on the substrate; a pixel electrode electrically connected to the thin film transistor; a first transparent planarization layer between the thin film transistor and the pixel electrode. KR 20130005854 A relates to a substrate for an organic electroluminescent device, and more particularly, to a thin film transistor including a thin film transistor including a polysilicon semiconductor layer, which simplifies the manufacturing process and prevents damage to wiring formed on the same layer by the same material as the source and drain electrode.

### SUMMARY

The present invention is set out in the appended set of claims, wherein the drawings and respective description relate to advantageous embodiments thereof.

In an existing display apparatus, power lines may possibly be damaged in a process performed after a process of forming power lines.

It was an object of the present invention to solve various problems including the aforementioned one and to provide a display apparatus with a low occurrence rate of defects during manufacture and a method of manufacturing the display apparatus. In particular, it was an object to provide a display apparatus wherein a damage, for example caused by gases, of certain parts of the display apparatus such as the power line and/or the pad may be effectively prevented or reduced.

However, this is merely an example, and the scope of the present disclosure is not limited thereto.

Additional aspects will be set forth in part in the description which follows and, in part, will be apparent from the description, or may be learned by practice of the presented embodiments of the disclosure.

According to one or more embodiments, a display apparatus includes: a transistor disposed above a substrate and including a semiconductor layer, a gate electrode overlapping the semiconductor layer, and a source-drain electrode, a first inorganic insulating layer disposed above the transistor, a first organic insulating layer disposed above the first inorganic insulating layer, a power line disposed above the first organic insulating layer and including a first conductive layer and a second conductive layer on the first conductive layer, a first protective layer comprising an inorganic insulating material, disposed between the first organic insulating layer and the power line and having a shape corresponding to a shape of the power line in a plan view, a second inorganic insulating layer disposed above the power line, a second organic insulating layer disposed above the second inorganic insulating layer, and a light-emitting diode disposed above the second organic insulating layer and including a pixel electrode, an opposite electrode, and an intermediate layer disposed between the pixel electrode and the opposite electrode. The second inorganic insulating layer directly contacts the first protective layer, and the power line is separated from the first organic insulating layer and the second organic insulating layer by the first protective layer and the second inorganic insulating layer.

The pixel electrode may be electrically connected to the a source-drain electrode through a first contact hole, the first contact hole may include a first portion, which is defined by the second organic insulating layer, the second inorganic insulating layer, and an upper portion of the first organic insulating layer, and a second portion, which is defined by the first inorganic insulating layer and a lower portion of the first organic insulating layer, and at a border between the first portion and the second portion, the first portion may have a first width, and the second portion may have a second width that is less than the first width in the plan view.

The border between the first portion and the second portion may be located between an upper surface and a lower surface of the first organic insulating layer.

The display apparatus may further include a pad including a fourth conductive layer, a fifth conductive layer, and a sixth conductive layer, which are sequentially stacked between the first organic insulating layer and the second inorganic insulating layer, and a second protective layer disposed between the first organic insulating layer and the pad and having a shape corresponding to a shape of the pad in the plan view, and the sixth conductive layer may include metal oxide.

The display apparatus may further include a pad opening defined by the second inorganic insulating layer and the second organic insulating layer and overlapping the pad in the plan view.

The power line may further include a third conductive layer disposed between the second conductive layer and the second inorganic insulating layer, and the sixth conductive layer may include the same material as the third conductive layer.

The display apparatus may further include: a pad disposed between the substrate and the first inorganic insulating layer and including a fourth conductive layer, a fifth conductive layer, and a sixth conductive layer, which are sequentially stacked, and a pad opening defined by the first inorganic insulating layer and the first organic insulating layer and overlapping the pad in the plan view, and the sixth conductive layer may include metal oxide.

The source-drain electrode may include a first sub-layer, a second sub-layer, and a third sub-layer which are sequentially stacked, and the sixth conductive layer may include the same material as the third sub-layer.

According to one or more embodiments, a display apparatus includes: a transistor disposed above a substrate and including a semiconductor layer, a gate electrode overlapping the semiconductor layer in a plan view, and a source-drain electrode, a first inorganic insulating layer disposed above the transistor, a first organic insulating layer disposed above the first inorganic insulating layer, a power line including a first molybdenum titanium (MoTi) layer disposed above the first organic insulating layer and a second conductive layer disposed above the first molybdenum titanium (MoTi) layer, a second inorganic insulating layer disposed above the power line, a second organic insulating layer disposed above the second inorganic insulating layer, and a light-emitting diode disposed above the second organic insulating layer and including a pixel electrode, an opposite electrode, and an intermediate layer disposed between the pixel electrode and the opposite electrode. The second inorganic insulating layer directly contacts the first molybdenum titanium (MoTi) layer, and second conductive layer is separated from the first organic insulating layer and the second organic insulating layer by the first molybdenum titanium (MoTi) layer and the second inorganic insulating layer

In the plan view, a shape of the first molybdenum titanium (MoTi) layer may correspond to a shape of the second conductive layer, and the second inorganic insulating layer may contact the first molybdenum titanium (MoTi) layer.

The display apparatus may further include: a pad including a second molybdenum titanium layer, a fifth conductive layer, and a sixth conductive layer which are sequentially stacked between the first organic insulating layer and the second inorganic insulating layer, and the sixth conductive layer may include metal oxide.

The pixel electrode may be electrically connected to the at least one source-drain electrode through a first contact hole, the first contact hole may include a first portion, which is defined by the second organic insulating layer, the second inorganic insulating layer, and an upper portion of the first organic insulating layer, and a second portion, which is defined by the first inorganic insulating layer and a lower portion of the first organic insulating layer, and, at a border between the first portion and the second portion, the first portion may have a first width, and the second portion may have a second width that is less than the first width in the plan view.
According to one or more embodiments, a method of manufacturing a display apparatus includes: forming, on a substrate, a transistor including a semiconductor layer, a gate electrode overlapping the semiconductor layer in a plan view, and a source-drain electrode; sequentially forming, on the transistor, a first inorganic insulating layer and a first organic insulating layer and forming a previous contact hole by removing a first portion of the first inorganic insulating layer and a portion of the first organic insulating layer; forming, on the first organic insulating layer, a power line including a first protective layer including an inorganic insulating material, a first conductive layer disposed above the first protective layer, and a second conductive layer disposed above the first conductive layer; sequentially forming, on the power line, a second inorganic insulating layer and a second organic insulating layer; forming a first contact hole by removing a second portion of the first inorganic insulating layer, a portion of the second inorganic insulating layer, and a portion of the second organic insulating layer; and forming, on the second organic insulating layer, a light-emitting diode including a pixel electrode, an opposite electrode, and an intermediate layer disposed between the pixel electrode and the opposite electrode. The previous contact hole is formed to overlap the second source-drain electrode in a plan view. The second portion of the first inorganic insulating layer, the portion of the second inorganic insulating layer, and the portion of the second organic insulating layer overlap the previous contact hole in the plan view.

The forming of the previous contact hole may include: forming a previous-sub hole penetrating the first organic insulating layer, and forming a groove by removing the first portion of the first inorganic insulating layer through the previous-sub hole.

In the sequentially forming of the second inorganic insulating layer and the second organic insulating layer, the second inorganic insulating layer may contact the first inorganic insulating layer through the previous contact hole.

The forming of the first contact hole includes: forming, in the plan view, a sub-hole overlapping the previous contact hole and penetrating the second organic insulating layer, and forming, through the sub-hole, a first portion of the first contact hole and a second portion of the first contact hole, where the first portion of the first contact hole is defined by the second organic insulating layer, the second inorganic insulating layer, and an upper portion of the first organic insulating layer, and the second portion of the first contact hole is defined by the first inorganic insulating layer and a lower portion of the first organic insulating layer.

At a border between the first portion and the second portion, the first portion may have a first width, and the second portion may have a second width that is less than the first width in the plan view.

In the forming of the power line, the first protective layer, the first conductive layer, and the second conductive layer may be patterned through the same mask process.

The method of manufacturing the display apparatus may further include: forming, on the first organic insulating layer, a pad including a second protective layer including an inorganic insulating material, and a fourth conductive layer, a fifth conductive layer, and a sixth conductive layer, which are sequentially stacked on the second protective layer, and the second protective layer, the fourth conductive layer, the fifth conductive layer, and the sixth conductive layer may be patterned through the same mask process.

The forming of the power line may further include forming a third conductive layer on the second conductive layer, and the third conductive layer may include the same material as the sixth conductive layer.

Other aspects, features, and advantages other than those described above will become apparent from the following detailed description, claims and drawings for carrying out the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of a display apparatus according to an embodiment;
FIG. 2 is an equivalent circuit diagram of a pixel included in a display apparatus, according to an embodiment;
FIG. 3 is a schematic plan view of region A of the display apparatus of FIG. 1;
FIGS. 4A and 4B are schematic cross-sectional views of a display apparatus according to an embodiment;
FIG. 5 is a schematic cross-sectional view of enlarged region E of the display apparatus of FIG. 4B;
FIG. 6 is a schematic cross-sectional view of enlarged region F of the display apparatus of FIGS. 4A and 4B;
FIG. 7 is a schematic cross-sectional view of enlarged region G of the display apparatus of FIGS. 4A and 4B;
FIG. 8 is a schematic cross-sectional view of a display apparatus according to another embodiment;
FIG. 9 is a schematic cross-sectional view of a display apparatus according to still another embodiment; and
FIGS. 10A to 10F are schematic cross-sectional views of processes of manufacturing the display apparatus of FIG. 4B.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, particular embodiments will be shown in the drawings and described in detail in the written description. The attached drawings for illustrating preferred embodiments of the present disclosure are referred to in order to gain a sufficient understanding of the present disclosure, the merits thereof, and the objectives accomplished by the implementation of the present disclosure. The disclosure may, however, be embodied in many different forms and should not be construed as being limited to the embodiments set forth herein.

Hereinafter, one or more embodiments of the disclosure will be described in detail with reference to the accompanying drawings. Like elements in the drawings denote like elements, and repeated descriptions thereof are omitted.

It will be understood that although the terms "first," "second," etc. may be used herein to describe various elements, these elements should not be limited by these terms, and these elements are only used to distinguish one element from another.

As used herein, the singular forms "a," "an," and "the" are intended to include the plural forms as well, unless the context clearly indicates otherwise.

It will be further understood that the terms "comprises" and/or "comprising" used herein specify the presence of stated features or elements, but do not preclude the presence or addition of one or more other features or elements.

It will be understood that when a layer, region, or element is referred to as being "formed on" another layer, region, or element, it can be directly or indirectly formed on the other layer, region, or element. That is, for example, intervening layers, regions, or elements may be present.

It will be understood that when a layer, region, or component is referred to as being connected to another layer, region, or component, it can be directly or indirectly connected to the other layer, region, or component. For example, when a layer, region, or component is referred to as being electrically connected to another layer, region, or component, it can be directly or indirectly electrically connected to the other layer, region, or component.

In the present embodiment, an expression such as "A and/or B" indicates A, B, or A and B. Also, an expression such as "at least one of A and B" indicates A, B, or A and B.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

Sizes of elements in the drawings may be exaggerated for convenience of explanation. In other words, since sizes and thicknesses of elements in the drawings are arbitrarily illustrated for convenience of explanation, the following embodiments are not limited thereto.

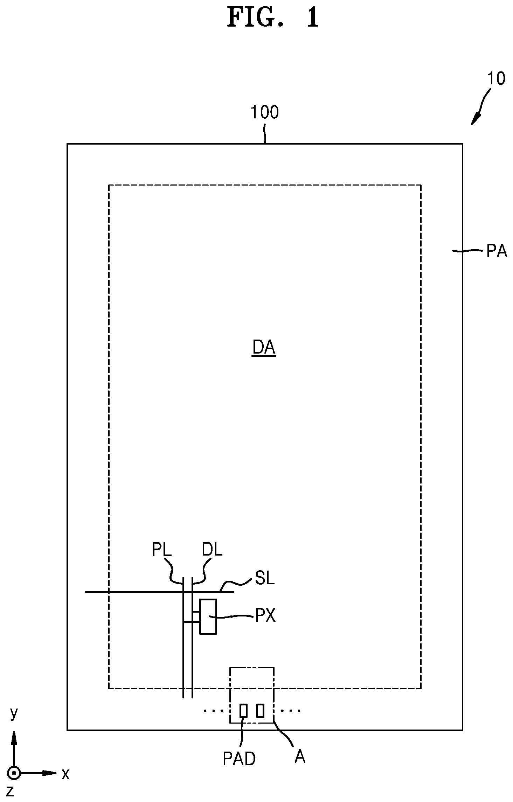

FIG. 1 is a schematic plan view of a display apparatus according to an embodiment.

Referring to FIG. 1, a display apparatus 10 including a display panel may be any type of display apparatus. For example, the display apparatus 10 may be various products, such as a smartphone, a tablet computer, a laptop, a television, or a billboard.

The display apparatus 10 includes a display area DA and a peripheral area PA outside the display area DA. FIG. 1 shows that the display area DA has a rectangular shape. However, one or more embodiments are not limited thereto. The display area DA may have various shapes, e.g., a circle, an oval, a polygon, and other specific shapes.

The display area DA is an area where images are displayed, and a plurality of pixels PX may be arranged therein. Each pixel PX may be defined as, for example, an emission area where red light, green light, or blue light is emitted. The pixel PX may include a light-emitting diode, such as an organic light-emitting diode. The light-emitting diode of the pixel PX may be connected to a pixel circuit including a thin-film transistor, a storage capacitor, and the like. The pixel circuit may be connected to a scan line SL configured to transmit a scan signal, a data line DL crossing the scan line SL and configured to transmit a data signal, a driving power line PL configured to supply a driving voltage, and the like. The scan line SL may extend in a first direction (e.g., an x direction), and the data line DL and the driving power line PL may each extend in a second direction (e.g., a y direction) crossing the first direction.

The pixel PX may emit light having a brightness corresponding to an electrical signal transmitted from a pixel circuit electrically connected to the pixel PX. In the display area DA, certain images may be displayed using light emitted from the pixels PX.

The peripheral area PA is an area where no pixel PX are arranged, and images are not displayed therein. In the peripheral area PA, a power line, etc. configured to drive the pixels PX may be located. Also, a pad PAD may be arranged in the peripheral area PA, wherein an integrated circuit device, e.g., a printed circuit board or a driver IC including driving circuitry, may be electrically connected to the pad PAD.

For reference, because the display apparatus 10 includes a substrate 100, it may be described that the substrate 100 includes the display area DA and the peripheral area PA.

Hereinafter, an organic light-emitting display apparatus is described as the display apparatus 10 according to an embodiment. However, the display apparatus 10 is not limited thereto. In another embodiment, for example, the display apparatus 10 may be an inorganic light-emitting display apparatus, an inorganic EL display apparatus, or a quantum dot light-emitting display apparatus.

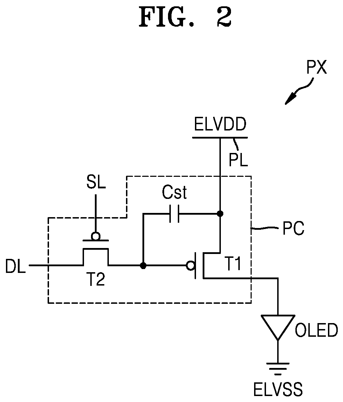

FIG. 2 is an equivalent circuit diagram of a pixel included in a display apparatus, according to an embodiment.

Referring to FIG. 2, one pixel PX may include a pixel circuit PC and an organic light-emitting diode OLED electrically connected thereto.

The pixel circuit PC may include a first transistor T1, a second transistor T2, and a storage capacitor Cst. The second transistor T2 may be a switching transistor, connected to the scan line SL and the data line DL, and turned on in response to a switching signal that is input through the scan line SL, thereby being configured to transmit a data signal, which is input through the data line DL, to the first transistor T1. An end of the storage capacitor Cst may be electrically connected to the second transistor T2, and the other end thereof may be electrically connected to the driving power line PL, and the storage capacitor Cst may store a voltage corresponding to a difference between a voltage from the second transistor T2 and a driving power voltage ELVDD supplied to the driving power line PL.

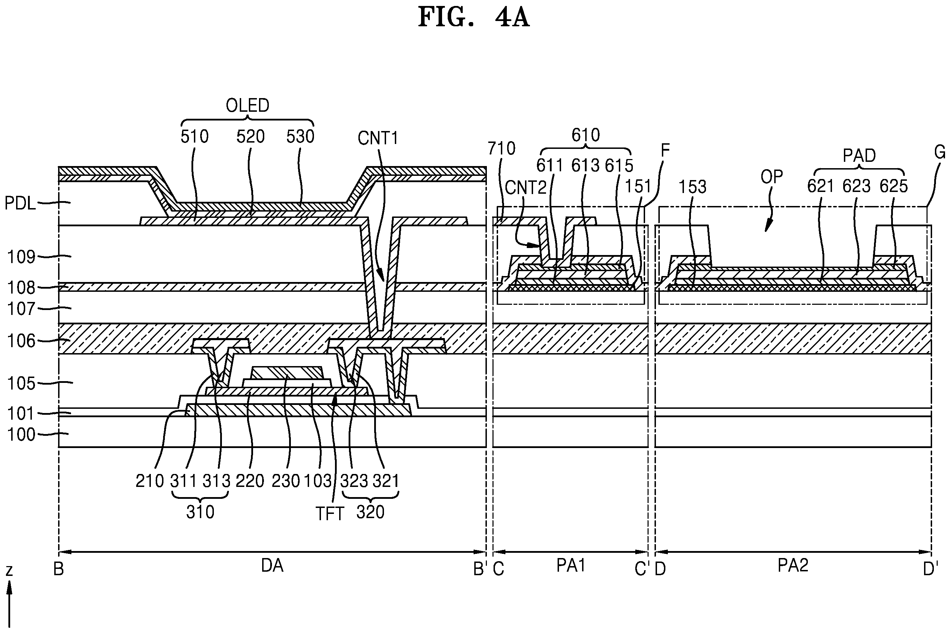

The first transistor T1 may be a driving transistor, connected to the driving power line PL and the storage capacitor Cst, and configured to control a size of a driving current flowing to the organic light-emitting diode OLED from the driving power line PL according to the voltage stored in the storage capacitor Cst. The organic light-emitting diode OLED may emit light having a certain brightness because of the driving current. An opposite electrode (530, see FIG. 4A) of the organic light-emitting diode OLED may receive a common power voltage ELVSS.

FIG. 2 shows that the pixel circuit PC includes two transistors and one storage capacitor, but one or more embodiments are not limited thereto. For example, the number of transistors or the number of storage capacitors may vary depending on the design of the pixel circuit PC.

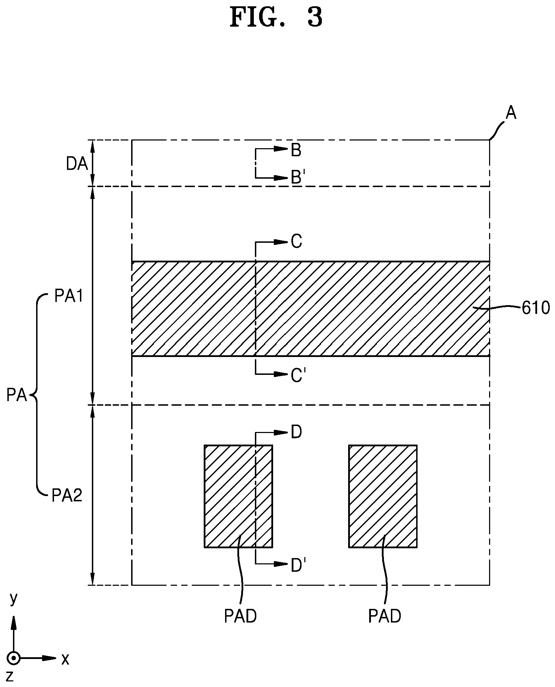

FIG. 3 is a schematic plan view of region A of the display apparatus of FIG. 1.

As shown in FIG. 3, the substrate 100 may include the display area DA and the peripheral area PA. The peripheral area PA may include a first peripheral area PA1 and a second peripheral area PA2. The first peripheral area PA1 may be arranged outside the display area DA to at least surround the same. The second peripheral area PA2 may be arranged outside the first peripheral area PA1. In an embodiment, for example, the first peripheral area PA1 may be located between the second peripheral area PA2 and the display area DA.

A power line 610 may be arranged in the first peripheral area PA1. The power line 610 may be part of large wiring through which a power voltage for driving an organic light-emitting diode (OLED, see FIG. 4A) is applied. In an embodiment, for example, the power line 610 may be a common power voltage (ELVSS, see FIG. 2) supply line in which a potential of the opposite electrode (530, see FIG. 4A) is constant in contact with the opposite electrode 530. Alternatively, the power line 610 may be a driving power voltage (ELVDD, see FIG. 2) supply line through which power is supplied to a thin-film transistor (TFT, see FIG. 4A). In an embodiment, when the power line 610 is the common power voltage supply line, the power line 610 may have a loop shape surrounding the display area DA in a plan view.

The pad PAD may be arranged in the second peripheral area PA2, wherein an integrated circuit device, e.g., a printed circuit board or a driver IC, is electrically connected to the pad PAD. Signal lines, e.g., the data lines (DL, see FIG. 1), which are arranged in the display area DA may be electrically connected to the pads PAD through input lines (not shown) arranged in the peripheral area PA.

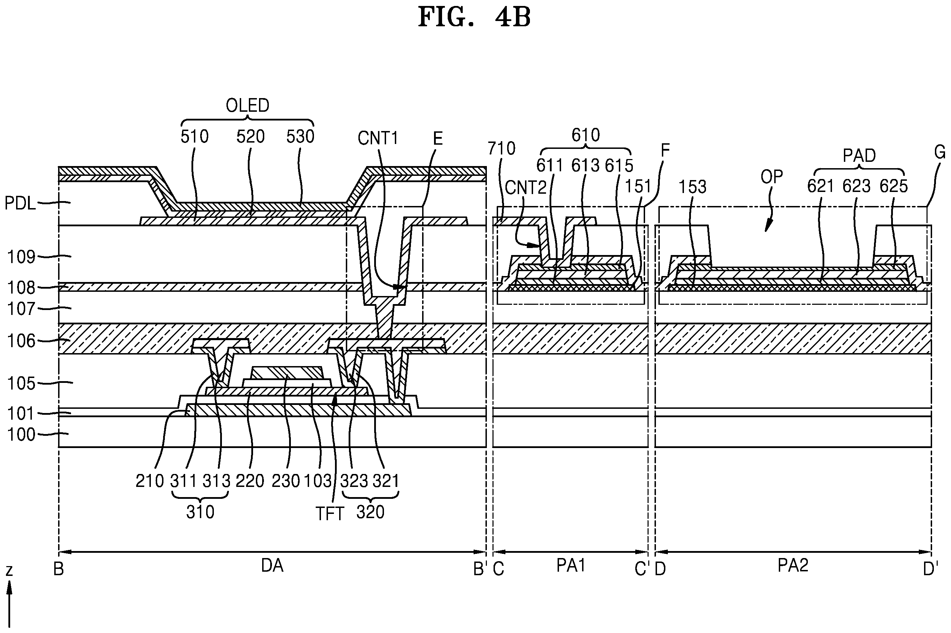

FIGS. 4A and 4B are schematic cross-sectional views of a display apparatus according to an embodiment. FIGS. 4A and 4B show cross-sections of the display apparatus of FIG. 3, taken along a line B-B', a line C-C', and a line D-D'.

Referring to FIGS. 4A and 4B, the display apparatus includes the substrate 100. The substrate 100 may include various materials that are flexible or bendable. In an embodiment, for example, the substrate 100 may include glass, metals, or polymer resin. Also, the substrate 100 may include polymer resin, such as polyethersulphone, polyacrylate, polyetherimide, polyethylene naphthalate, polyethylene terephthalate, polyphenylene sulfide, polyarylate, polyimide, polycarbonate, or cellulose acetate propionate. Various modifications may be made to the substrate 100; for example, the substrate 100 may have a multilayered structure that includes two layers including the above polymer resin and a barrier layer including an inorganic material (e.g., silicon oxide, silicon nitride, silicon oxynitride, or the like) and arranged between the two layers.

A buffer layer 101 may be disposed above the substrate 100. The buffer layer 101 may decrease or prevent the penetration of foreign materials, moisture, or external air from the bottom of the substrate 100 and may provide a flat surface on the substrate 100. The buffer layer 101 may include an inorganic material, such as silicon oxide, silicon nitride, and/or silicon oxynitride, an organic material, or an organic and inorganic compound, and may have a single-layer structure of an organic material or an inorganic material or a multilayered structure that includes both.

According to one embodiment, a transistor may be disposed above a substrate 100 and comprising a semiconductor layer 220, a gate electrode 230 overlapping the semiconductor layer 220, and at least one source-drain electrode. The organic light-emitting diode OLED and the thin-film transistor TFT electrically connected thereto may be disposed above the substrate 100. The electrical connection of the organic light-emitting diode OLED to the thin-film transistor TFT may be understood as the electrical connection of a pixel electrode 510 of the organic light-emitting diode OLED to the thin-film transistor TFT. In an embodiment, the thin-film transistor TFT may be a driving transistor.

The thin-film transistor TFT may include a semiconductor layer 220 including amorphous silicon, polycrystalline silicon, an organic semiconductor material, or an oxide semiconductor material. The thin-film transistor TFT may include a gate electrode 230, a first source-drain electrode 310, and a second source-drain electrode 320. The gate electrode 230 may include various conductive materials and have various layer structures. In an embodiment, for example, the gate electrode 230 may include a molybdenum (Mo) layer and an aluminum (Al) layer. Alternatively, the gate electrode 230 may include a titanium nitride (TiN) layer, an Al layer, and/or a titanium (Ti) layer.

A gate insulating layer 103 may be disposed between the semiconductor layer 220 and the gate electrode 230. The gate insulating layer 103 may include an inorganic insulating material, such as silicon oxide, silicon nitride, and/or silicon oxynitride. FIGS. 4A and 4B show that the gate insulating layer 103 is patterned together with the gate electrode 230 in the same mask process and thus has the shape corresponding to the shape of the gate electrode 230 in a plan view, but one or more embodiments are not limited thereto. In another embodiment, for example, the gate insulating layer 103 may cover the entirety of the display area DA. In the present specification, the description "the shape of A corresponds to the shape of B in a plan view" may indicate that A and B are patterned together through the same mask process so that the boundary of A overlaps the boundary of B when viewed in a plan view. In this case, the width of A may be less or greater than the width of B because of a difference in etch rates of A and B, etc., and even in this case, the shape of A may correspond to the shape of B.

An interlayer-insulating layer 105 may be disposed above the gate electrode 230. The interlayer-insulating layer 105 may include an inorganic insulating material, such as silicon oxide, silicon nitride, and/or silicon oxynitride, and may have a single-layer structure or a multilayered structure including the above material.

The first source-drain electrode 310 and the second source-drain electrode 320 may be disposed above the interlayer-insulating layer 105. Any one of the first source-drain electrode 310 and the second source-drain electrode 320 may contact a source area of the semiconductor layer 220, and the other thereof may contact a drain area of the semiconductor layer 220. In other words, any one of the first source-drain electrode 310 and the second source-drain electrode 320 may be a source electrode, and the other thereof may be a drain electrode. In an embodiment, the semiconductor layer 220 of the thin-film transistor TFT may be connected to a semiconductor layer 220 of another adjacent thin-film transistor TFT, and any one of the first source-drain electrode 310 and the second source-drain electrode 320 may be omitted.

The first source-drain electrode 310 and the second source-drain electrode 320 may each have a multilayered structure. According to an embodiment, at least one source-drain electrode 310,320 may comprise a first sub-layer 311, a second sub-layer 313, and a third sub-layer 321, which are sequentially stacked. The first source-drain electrode 310 may include a first sub-layer 311 and a second sub-layer 313, and the second source-drain electrode 320 may include a third sub-layer 321 and a fourth sub-layer 323. The first sub-layer 311 may include the same material as the third sub-layer 321. The second sub-layer 313 may include the same material as the fourth sub-layer 323. In the present specification, the description "A includes the same material as B" indicates that A and B are formed through the same deposition process and have the same composition, film quality, and/or layer structure.

In an embodiment, the first sub-layer 311 and the third sub-layer 321 may each include Ti. The second sub-layer 313 and the fourth sub-layer 323 may each include Al or copper (Cu).

A lower metal layer 210 may be disposed between the substrate 100 and the semiconductor layer 220. In an embodiment, for example, the lower metal layer 210 may be disposed between the substrate 100 and the buffer layer 101. In an embodiment, the second source-drain electrode 320 may contact the lower metal layer 210. In an embodiment, a portion of the lower metal layer 210 may be a lower electrode of the storage capacitor (Cst, see FIG. 2). For reference, the storage capacitor Cst may include an upper electrode overlapping the lower electrode, and the upper electrode is not shown in FIGS. 4A and 4B. However, the upper electrode may be disposed in the same layer and include the same material as the gate electrode 230. However, one or more embodiments are not limited thereto. In another embodiment, for example, the lower metal layer 210 may not contact the thin-film transistor TFT. In this case, the lower metal layer 210 may not contact the second source-drain electrode 320 and have an isolated shape.

According to necessity, the driving power voltage (ELVDD, see FIG. 2), which is a constant voltage, may be applied to the lower metal layer 210. In this case, the lower metal layer 210 may shield the thin-film transistor TFT. The lower metal layer 210 may include a metal material.

A first inorganic insulating layer 106 may be disposed above the first source-drain electrode 310 and the second source-drain electrode 320. According to one embodiment, a first inorganic insulating layer 106 may be disposed above the transistor TFT. The first inorganic insulating layer 106 may include silicon oxide, silicon nitride, and/or silicon oxynitride. The first inorganic insulating layer 106 may be formed through chemical vapor deposition ("CVD"). The formation method is also applied to the embodiments below and modified examples thereof.

A first organic insulating layer 107 may be disposed above the first inorganic insulating layer 106. The first organic insulating layer 107 may function as a planarization layer to provide a flat upper surface by burying uneven portions formed because of the thin-film transistor TFT. The first organic insulating layer 107 may include an organic insulating material. In an embodiment, for example, the first organic insulating layer 107 may include a general-purpose polymer, such as benzocyclobutene ("BCB"), polyimide, hexamethyldisiloxane ("HMDSO"), polymethylmethacrylate ("PMMA"), or polystyrene ("PS"), a polymer derivative having a phenol-based group, an acrylic-based polymer, an imide-based polymer, an aryl-ether-based polymer, an amide-based polymer, a fluorine-based polymer, a p-xylene-based polymer, a vinyl alcohol-based polymer, and any blend thereof.

The first inorganic insulating layer 106 may effectively prevent or reduce the damage to the first source-drain electrode 310 and the second source-drain electrode 320, where the damage is caused by gases, etc. generated from the first organic insulating layer 107 during the manufacturing of the display apparatus.

In the first peripheral area PA1, the power line 610 may be disposed above the first organic insulating layer 107. As described above, the power line 610 may be the common power voltage (ELVSS, see FIG.2) supply line or the driving power voltage (ELVDD, see FIG. 2) supply line.

The power line 610 may include a first conductive layer 611 and a second conductive layer 613 which are sequentially stacked. The first conductive layer 611 and the second conductive layer 613 may include different conductive materials. The first conductive layer 611 may include Ti, and the second conductive layer 613 may include Al and/or Cu. In an embodiment, the power line 610 may further include a third conductive layer 615 disposed above the second conductive layer 613. The third conductive layer 615 may include metal oxide. In an embodiment, for example, the metal oxide may include indium tin oxide ("ITO").

A first protective layer 151 may be disposed between the power line 610 and the first organic insulating layer 107. According to one embodiment, the first protective layer 151 may have a shape corresponding to a shape of the power line 610 in a plan view. The first protective layer 151 may include an inorganic insulating material, such as silicon oxide, silicon nitride, and/or silicon oxynitride. The first protective layer 151 may be formed through CVD.

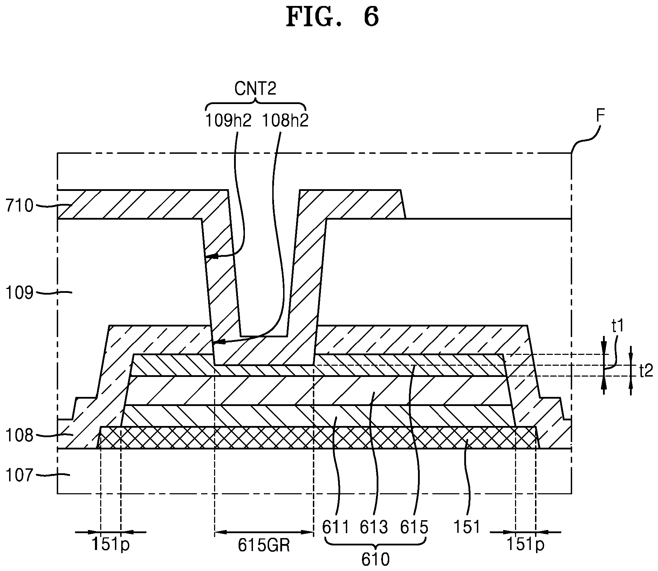

In a plan view, the shape of the first protective layer 151 may correspond to the shape of the power line 610. In other words, the first protective layer 151 may be patterned together with the power line 610 through the same mask process. The power line 610 and the first protective layer 151 are described below in more detail with reference to FIG. 6.

In the second peripheral area PA2, the pad PAD may be disposed above the first organic insulating layer 107. The pad PAD may include a fourth conductive layer 621, a fifth conductive layer 623, and a sixth conductive layer 625 which are sequentially stacked, preferably which may be sequentially stacked between the first organic insulating layer 107 and the second inorganic insulating layer 108. The fourth conductive layer 621, the fifth conductive layer 623, and the sixth conductive layer 625 may include different materials. The fourth conductive layer 621 may include Ti, the fifth conductive layer 623 may include Al or Cu, and the sixth conductive layer 625 may include metal oxide. Here, the metal oxide may include ITO.

In an embodiment, the fourth conductive layer 621 may include the same material as the first conductive layer 611. The fifth conductive layer 623 may include the same material as the second conductive layer 613, and the sixth conductive layer 625 may include the same material as the third conductive layer 615.
A second protective layer 153 may be disposed between the pad PAD and the first organic insulating layer 107, preferably the second protective layer 153 may have a shape corresponding to a shape of the pad PAD in the plan view.

The second protective layer 153 may include an inorganic insulating material, such as silicon oxide, silicon nitride, and/or silicon oxynitride. The second protective layer 153 may be formed through CVD. In an embodiment, the first protective layer 151 may include the same material as the second protective layer 153.

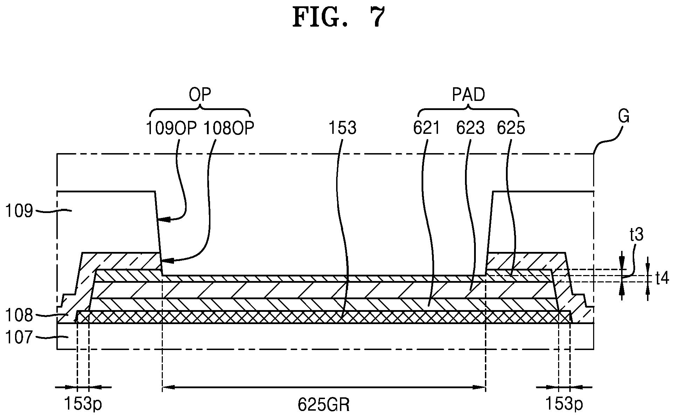

In a plan view, the shape of the second protective layer 153 may correspond to the shape of the pad PAD. In other words, the second protective layer 153 may be patterned together with the pad PAD through the same mask process. The pad PAD and the second protective layer 153 are described below in more detail with reference to FIG. 7.

A second inorganic insulating layer 108 may be disposed above the first organic insulating layer 107 to cover the power line 610 and the pad PAD. The second inorganic insulating layer 108 may include silicon oxide, silicon nitride, and/or silicon oxynitride.

A second organic insulating layer 109 may be disposed above the second inorganic insulating layer 108. The second organic insulating layer 109 may function as a planarization layer to provide a flat upper surface to the organic light-emitting diode OLED. The second organic insulating layer 109 may include an organic insulating material. In an embodiment, for example, the second organic insulating layer 109 may include a general-purpose polymer, such as BCB, polyimide, HMDSO, PMMA, or PS, a polymer derivative having a phenol-based group, an acrylic-based polymer, an imide-based polymer, an aryl-ether-based polymer, an amide-based polymer, a fluorine-based polymer, a p-xylene-based polymer, a vinyl alcohol-based polymer, and any blend thereof.

According to the invention, the second inorganic insulating layer 108 directly contacts the first protective layer 151 and the second protective layer 153 and the power line 610 is separated from the first organic insulating layer 107 and the second organic insulating layer 109 by the first protective layer 151 and the second inorganic insulating layer 108, respectively. The pad PAD may be separated from the first organic insulating layer 107 and the second organic insulating layer 109 by the second protective layer 153 and the second inorganic insulating layer 108, respectively. Therefore, the damage to the power line 610 and the pad PAD may be effectively prevented or reduced, where the damage is caused by gases, etc. which are generated from the first organic insulating layer 107 and the second organic insulating layer 109 during the manufacture of the display apparatus.

An opening OP may be arranged, wherein the opening OP overlaps the pad PAD and exposes an upper surface of the pad PAD from the second inorganic insulating layer 108 and the second organic insulating layer 109. The opening OP may be defined by the second inorganic insulating layer 108 and the second organic insulating layer 109. The pad PAD may be electrically connected to the integrated circuit device and/or the printed circuit board through the opening OP. The opening OP may be referred to as an "pad opening". According to one embodiment, a pad opening may be defined by the second inorganic insulating layer 108 and the second organic insulating layer 109 and overlapping the pad PAD in the plan view.

According to one embodiment, the light-emitting diode OLED may be disposed above the second organic insulating layer 109 and may comprise a pixel electrode 510, an opposite electrode 530, and an intermediate layer 520 disposed between the pixel electrode 510 and the opposite electrode 530.

In the display area DA, the organic light-emitting diode OLED may be disposed above the second organic insulating layer 109. The organic light-emitting diode OLED may include, for example, the pixel electrode 510, the opposite electrode 530, and an intermediate layer 520 arranged therebetween and including an emission layer.

According to one embodiment, the pixel electrode 510 may be electrically connected to one of the first source-drain electrode 310 and the second source-drain electrode 320 through a first contact hole CNT1. The pixel electrode 510 may contact the second source-drain electrode 320 through a first contact hole CNT1 penetrating the second organic insulating layer 109, the second inorganic insulating layer 108, the first organic insulating layer 107, and the first inorganic insulating layer 106 and may be electrically connected to the thin-film transistor TFT. In other words, the first contact hole CNT1 may be defined by the first inorganic insulating layer 106, the first organic insulating layer 107, the second inorganic insulating layer 108, and the second organic insulating layer 109.

In an embodiment, as shown in FIG. 4B, the first contact hole CNT1 may have a width that discontinuously changes between an upper surface and a lower surface of the first organic insulating layer 107 in a plan view.

The pixel electrode 510 may be a (semi-)light-transmissive electrode or a reflection electrode. In an embodiment, the pixel electrode 510 may include a reflection film including silver (Ag), magnesium (Mg), Al, platinum (Pt), palladium (Pd), gold (Au), nickel (Ni), neodymium (Nd), iridium (Ir), chromium (Cr), or a compound thereof, and a transparent or translucent electrode layer disposed on the reflection film. The transparent or translucent electrode layer may include at least one material selected from the group consisting of ITO, indium zinc oxide ("IZO"), zinc oxide (ZnO), indium oxide (In₂O₃), indium gallium oxide ("IGO"), and aluminum zinc oxide ("AZO"). In an embodiment, the pixel electrode 510 may have a stack structure of ITO/Ag/ITO.

The intermediate layer 520 of the organic light-emitting diode OLED may include an organic emission layer. The organic emission layer may include an organic material including a fluorescent or phosphorescent material emitting red light, green light, blue light, or white light. The organic emission layer may include a low-molecular-weight or a high-molecular-weight organic material, and on and under the organic emission layer, functional layers, such as a hole transport layer ("HTL"), a hole injection layer ("HIL"), an electron transport layer ("ETL"), and an electron injection layer ("EIL"), may be selectively arranged. The aforementioned layers may be formed through inkjet printing, screen printing, or laser induced thermal imaging ("LITI").

The intermediate layer 520 is not limited thereto and may have various structures. The intermediate layer 520 may include a layer integrally formed as a single body over the pixel electrodes 510 and a layer patterned to correspond to each of the pixel electrodes 510.

The opposite electrode 530 may be disposed to cover the display area DA. The opposite electrode 530 may be integrally formed over the organic light-emitting diodes OLED and thus may correspond to the pixel electrodes 510. The opposite electrode 530 may include a light-transmissive conductive layer including ITO, In₂O₃, or IZO and also include a semi-transmissive layer including metal, such as Al or Ag. In an embodiment, for example, the opposite electrode 530 may be a semi-transmissive layer including MgAg.

In the first peripheral area PA1, a connection line 710 may be disposed above the second organic insulating layer 109. The connection line 710 may be a bridge line for electrically connecting the power line 610 to the organic light-emitting diode OLED or the thin-film transistor TFT which is in the display area DA. The connection line 710 may include the same material as the pixel electrode 510. In an embodiment, for example, when the pixel electrode 510 includes a stack structure of ITO/Ag/ITO, the connection line 710 may also have the stack structure.

The connection line 710 may contact the power line 610 through a second contact hole CNT2 penetrating the second organic insulating layer 109 and the second inorganic insulating layer 108. The second contact hole CNT2 may be defined by the second inorganic insulating layer 108 and the second organic insulating layer 109.

In the display area DA, a pixel-defining layer PDL may be disposed above the second organic insulating layer 109. The pixel-defining layer PDL may define emission areas of the pixels PX by including an opening corresponding to each pixel PX, that is, an opening exposing at least a portion of the pixel electrode 510. Also, the pixel-defining layer PDL prevents arcs, etc. from being generated at the edges of the pixel electrode 510 by increasing the distance between the edges of the pixel electrode 510 and the opposite electrode 530. The pixel-defining layer PDL may include an organic insulating material, such as polyimide, polyamide, acrylic resin, BCB, HMDSO, or phenol resin, and may be formed through spin coating or the like.

Because the organic light-emitting diode OLED described may be easily damaged by external moisture or oxygen, an encapsulation layer (not shown) may be arranged to cover the organic light-emitting diode OLED. The encapsulation layer (not shown) may include at least one inorganic encapsulation layer and at least one organic encapsulation layer. The encapsulation layer (not shown) may cover the display area DA and extend to part of the first peripheral area PA1 and the second peripheral area PA2 outside the display area DA.

In the display apparatus according to an embodiment, the power line 610 and the pad PAD are formed at a different layer from the first source-drain electrode 310 and the second source-drain electrode 320, and thus, a high-resolution pixel arrangement may be possible.

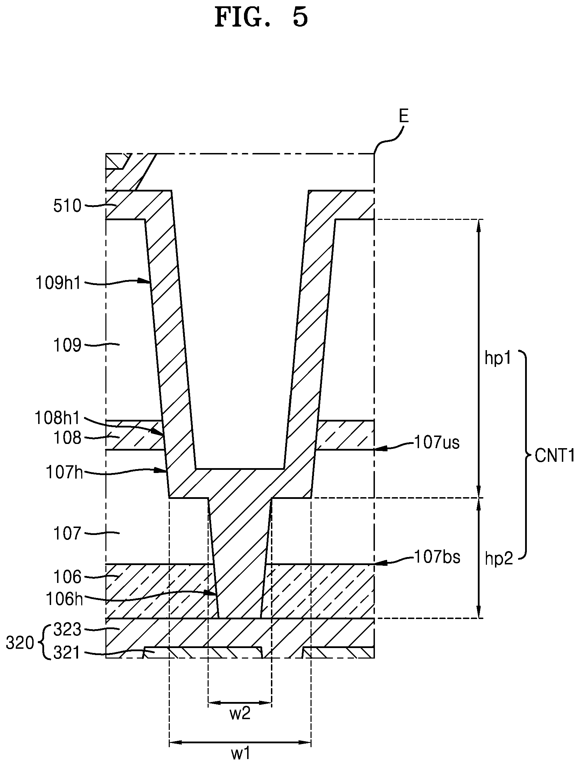

FIG. 5 is a schematic cross-sectional view of enlarged region E of the display apparatus of FIG. 4B.

Referring to FIG. 5, the pixel electrode 510 may contact an upper surface of the second source-drain electrode 320 through the first contact hole CNT1 penetrating the second organic insulating layer 109, the second inorganic insulating layer 108, the first organic insulating layer 107, and the first inorganic insulating layer 106. The second source-drain electrode 320 may include the third sub-layer 321 and the fourth sub-layer 323, and the pixel electrode 510 may contact the fourth sub-layer 323.

The first contact hole CNT1 may include a first sub-hole 106h, a second sub-hole 107h, a third sub-hole 108h1, and a fourth sub-hole 109h1, which overlap each other. The first sub-hole 106h may be defined by the first inorganic insulating layer 106, the second sub-hole 107h may be defined by the first organic insulating layer 107, the third sub-hole 108h1 may be defined by the second inorganic insulating layer 108, and the fourth sub-hole 109h1 may be defined by the second organic insulating layer 109.
The first contact hole CNT1 may include a first portion hp1, which is defined by the second organic insulating layer 109, the second inorganic insulating layer 108, and an upper portion of the first organic insulating layer 107, and a second portion hp2, which is defined by a lower portion of the first organic insulating layer 107 and the first inorganic insulating layer 106. The upper portion of the first organic insulating layer 107 may be adjacent to an upper surface 107us of the first organic insulating layer 107, on which the first organic insulating layer 107 contacts the second inorganic insulating layer 108, and the lower portion of the first organic insulating layer 107 may be adjacent to a bottom surface 107bs of the first organic insulating layer 107, on which the first organic insulating layer 107 contacts the first inorganic insulating layer 106. According to an embodiment, at a border between the first portion hp1 and the second portion hp2, the first portion hp1 may have a first width w1, and the second portion hp2 may have a second width w2 that is less than the first width w1 in the plan view.

The width of the first portion hp1 of the first contact hole CNT1 may be different from the width of the second portion hp2 of the first contact hole CNT1 in a plan view. In an embodiment, for example, the width of the first portion hp1 of the first contact hole CNT1 may be greater than the width of the second portion hp2 of the first contact hole CNT1. At a border between the first portion hp1 and the second portion hp2, the first portion hp1 may have a first width w1, and the second portion hp2 may have a second width w2 that is less than the first width w1 in a plan view. The width of the first contact hole CNT1 may decrease in a direction from top to the bottom of the first contact hole CNT1. The point (i.e., the border between the first portion hp1 and the second portion hp2) where the first contact hole CNT1 may have the width that discontinuously changes may be located between the upper surface 107us and the bottom surface 107bs of the first organic insulating layer 107.

In an embodiment, the first contact hole CNT1 may comprise a first portion hp1, which may be defined by the second organic insulating layer 109, the second inorganic insulating layer 108, and an upper portion of the first organic insulating layer 107, and a second portion hp2, which may be defined by the first inorganic insulating layer 106 and a lower portion of the first organic insulating layer 107, and at a border between the first portion hp1 and the second portion hp2, the first portion hp1 may have a first width w1, and the second portion hp2 may have a second width w2 that is less than the first width in the plan view.

In an embodiment, a thickness of the lower portion of the first organic insulating layer 107 may be greater than a thickness of the upper portion of the first organic insulating layer 107, for example, the thickness of the lower portion is 4 times or more of the thickness of the upper portion.

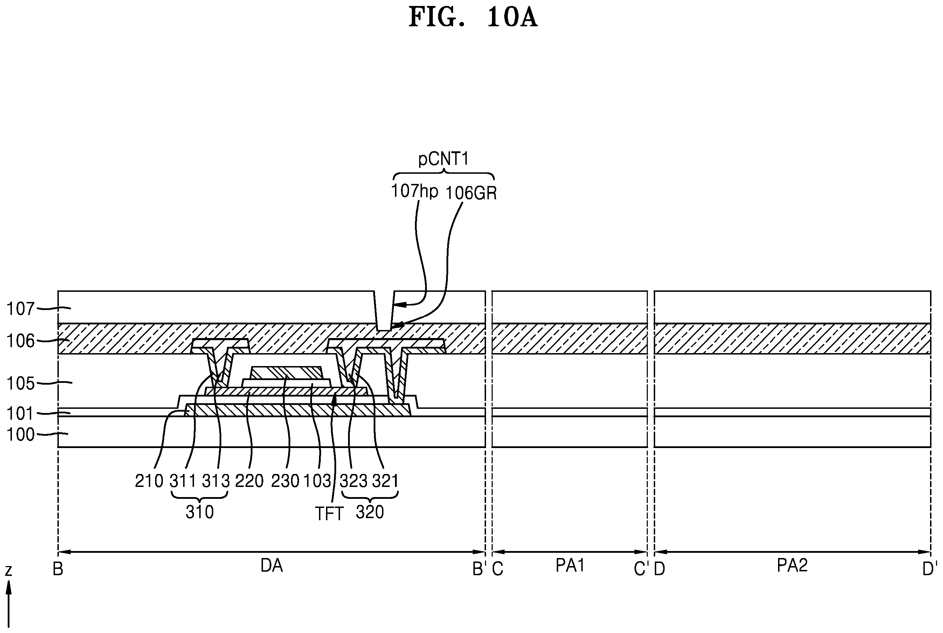

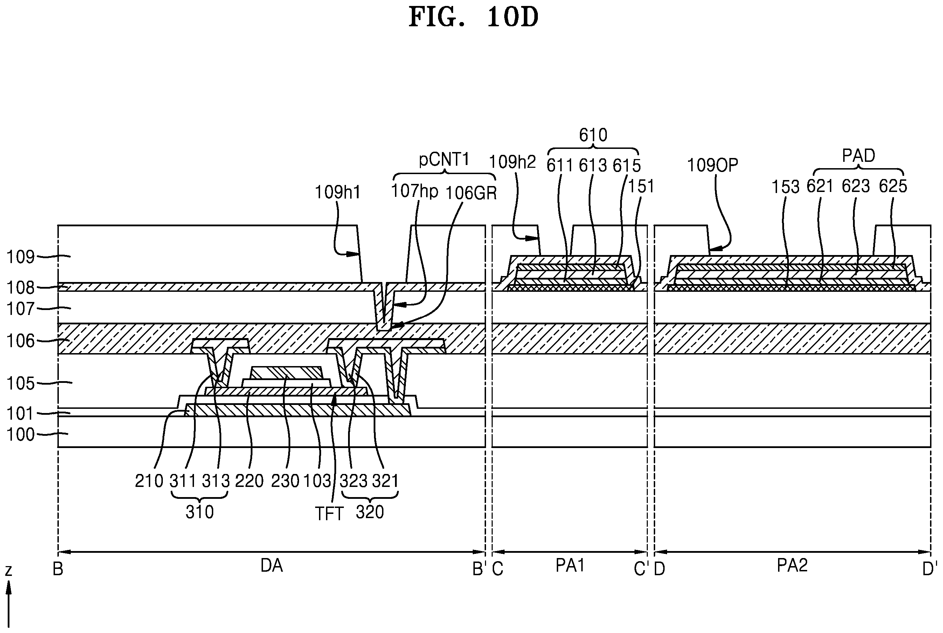

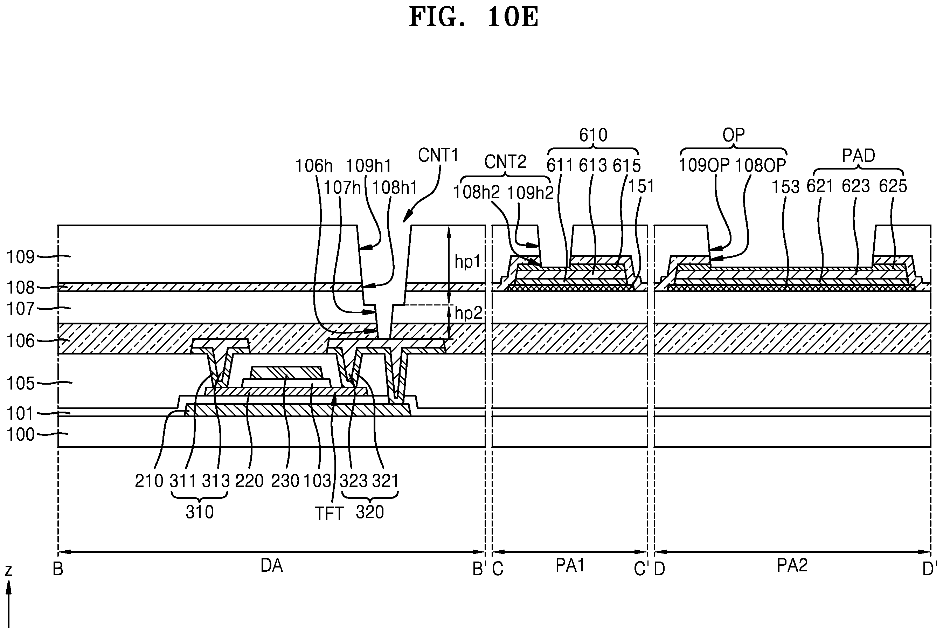

The first contact hole CNT1 may be formed through a first etching process of etching the first organic insulating layer 107 and a portion (i.e., upper portion) of the first inorganic insulating layer 106 (See FIG. 10A), a second etching process of etching the second organic insulating layer 109 (See FIG. 10D), and a third etching process of etching the second inorganic insulating layer 108 and remaining portions (i.e., the lower portion) of the first inorganic insulating layer 106 (See FIG. 10E). As at least a portion (i.e., lower portion) of the first inorganic insulating layer 106 is etched together with the second inorganic insulating layer 108 in a process of forming the first contact hole CNT1, the damage to the upper surface of the second source-drain electrode 320 may be effectively prevented or reduced, where the damage is caused during the manufacture of the display apparatus.

FIG. 6 is a schematic cross-sectional view of enlarged region F of the display apparatus of FIGS. 4A and 4B.

Referring to FIG. 6, the power line 610 may be disposed above the first organic insulating layer 107. The power line 610 may include the first conductive layer 611 and the second conductive layer 613 which include different conductive materials. The first conductive layer 611 and the second conductive layer 613 may have different metal materials. In an embodiment, for example, the first conductive layer 611 may include Ti, and the second conductive layer 613 may include Al or Cu. In an embodiment, the power line 610 may further include the third conductive layer 615 disposed above the second conductive layer 613. In an embodiment, for example, when the power line 610 is disposed in the same layer as the pad (PAD, see FIG. 4A), the power line 610 may have a three-layer structure including the first conductive layer 611, the second conductive layer 613, and the third conductive layer 615. The third conductive layer 615 may include metal oxide. The metal oxide may include ITO.

The first protective layer 151 may be disposed between the power line 610 and the first organic insulating layer 107. The first protective layer 151 may include an inorganic insulating material, such as silicon oxide, silicon nitride, and/or silicon oxynitride. The first protective layer 151 may be formed through CVD.

Because the power line 610 is formed together with the first protective layer 151 through the same mask process (a patterning process), the shape of the first protective layer 151 may correspond to the shape of the power line 610 in a plan view. In an embodiment, a portion 151p of the first protective layer 151 may protrude towards the outside of the power line 610 because of a difference in the etch rates of the first protective layer 151 and the power line 610.

The second inorganic insulating layer 108 may be disposed above the power line 610. The second inorganic insulating layer 108 may include an inorganic insulating material, such as silicon oxide, silicon nitride, and/or silicon oxynitride. The second inorganic insulating layer 108 may cover upper and side surfaces of the power line 610 and prevent the first conductive layer 611, the second conductive layer 613, and the third conductive layer 615 from directly contacting the second organic insulating layer 109.

The second organic insulating layer 109 may be disposed above the second inorganic insulating layer 108. The second organic insulating layer 109 may provide a flat upper surface by burying uneven portions formed due to a lower structure. The second organic insulating layer 109 may include an organic insulating material.

The second inorganic insulating layer 108 may directly contact the portion 151p of the first protective layer 151. The upper, lower, and side surfaces of the power line 610 may be separated from the first organic insulating layer 107 and the second organic insulating layer 109 by the first protective layer 151 and the second inorganic insulating layer 108. Therefore, the damage to the power line 610 may be effectively prevented or reduced, where the damage is caused by gases, etc. which are generated from the first organic insulating layer 107 and the second organic insulating layer 109 during the manufacture of the display apparatus.

The connection line 710 may be disposed above the second organic insulating layer 109. The connection line 710 may be a bridge line for electrically connecting the power line 610 to the organic light-emitting diode OLED or the thin-film transistor TFT which is in the display area DA.

The connection line 710 may contact the power line 610 through the second contact hole CNT2 penetrating the second inorganic insulating layer 108 and the second organic insulating layer 109. The second contact hole CNT2 may include a fifth sub-hole 108h2 and a sixth sub-hole 109h2. The fifth sub-hole 108h2 may be defined by the second inorganic insulating layer 108, and the sixth sub-hole 109h2 may be defined by the second organic insulating layer 109.

The third conductive layer 615 of the power line 610 may define a first groove 615GR. The first groove 615GR may overlap the second contact hole CNT2. In an embodiment, for example, the first groove 615GR may be formed as a portion of the third conductive layer 615 is etched in the process of forming the second contact hole CNT2. Therefore, the third conductive layer 615 of the power line 610 may have a thickness that is less than the thickness of a peripheral area, in an area where the third conductive layer 615 contacts the second contact hole CNT2. In an embodiment, for example, the third conductive layer 615 of the power line 610 may have a first thickness t1 on an outer side of the first groove 615GR and a second thickness t2 on an inner side of the first groove 615GR. In this case, the second thickness t2 may be less than the first thickness t1.

FIG. 7 is a schematic cross-sectional view of enlarged region G of the display apparatus of FIGS. 4A and 4B.

Referring to FIG. 7, the pad PAD may be disposed above the first organic insulating layer 107. The pad PAD may include the fourth conductive layer 621, the fifth conductive layer 623, and the sixth conductive layer 625 which include different conductive materials. The fourth conductive layer 621 and the fifth conductive layer 623 may have different metal materials. In an embodiment, for example, the fourth conductive layer 621 may include Ti, and the fifth conductive layer 623 may include Al or Cu. The sixth conductive layer 625 may include metal oxide. The metal oxide may include ITO.

The second protective layer 153 may be disposed between the pad PAD and the first organic insulating layer 107. The second protective layer 153 may include an inorganic insulating material, such as silicon oxide, silicon nitride, and/or silicon oxynitride. The second protective layer 153 may be formed through CVD.

Because the pad PAD is formed together with the second protective layer 153 through the same mask process (the patterning process), the shape of the second protective layer 153 may correspond to the shape of the pad PAD when viewed in a plan view. In an embodiment, a portion 153p of the second protective layer 153 may protrude towards the outside of the pad PAD because of a difference in the etch rates of the second protective layer 153 and the pad PAD.

The second inorganic insulating layer 108 may be disposed above the pad PAD. The second inorganic insulating layer 108 may include an inorganic insulating material, such as silicon oxide, silicon nitride, and/or silicon oxynitride. The second inorganic insulating layer 108 may cover the upper and side surfaces of the pad PAD and prevent the fourth conductive layer 621, the fifth conductive layer 623, and the sixth conductive layer 625 from directly contacting the second organic insulating layer 109.

The second organic insulating layer 109 may be disposed above the second inorganic insulating layer 108. The second organic insulating layer 109 may provide a flat upper surface by burying uneven portions formed due to a lower structure. The second organic insulating layer 109 may include an organic insulating material.

The opening OP may be arranged, wherein the opening OP overlaps the pad PAD and exposes the upper surface of the pad PAD from the second inorganic insulating layer 108 and the second organic insulating layer 109. The opening OP may include a first sub-opening 108OP and a second sub-opening 109OP which overlap each other. The first sub-opening 108OP may be defined by the second inorganic insulating layer 108, and the second sub-opening 109OP may be defined by the second organic insulating layer 109. The pad PAD may be electrically connected to the integrated circuit device and/or the printed circuit board through the opening OP.

The sixth conductive layer 625 of the pad PAD may define a second groove 625GR. The second groove 625GR may overlap the opening OP. In an embodiment, for example, the second groove 625GR may be formed as a portion of the sixth conductive layer 625 is etched in the process of forming the opening OP. Therefore, the sixth conductive layer 625 of the pad PAD may have a thickness that is less than the thickness of the peripheral area, in an area where the sixth conductive layer 625 overlaps the opening OP. In an embodiment, for example, the sixth conductive layer 625 of the pad PAD may have a third thickness t3 on an outer side of the second groove 625GR and a fourth thickness t4 on an inner side of the second groove 625GR. In this case, the fourth thickness t4 may be less than the third thickness t3.

The second inorganic insulating layer 108 may directly contact the portion 153p of the second protective layer 153. The upper, lower, and side surfaces of the pad PAD may be separated from the first organic insulating layer 107 and the second organic insulating layer 109 by the second protective layer 153 and the second inorganic insulating layer 108. Therefore, the damage to the pad PAD may be effectively prevented or reduced, where the damage is caused by gases, etc. which are generated from the first organic insulating layer 107 and the second organic insulating layer 109 during the manufacture of the display apparatus.

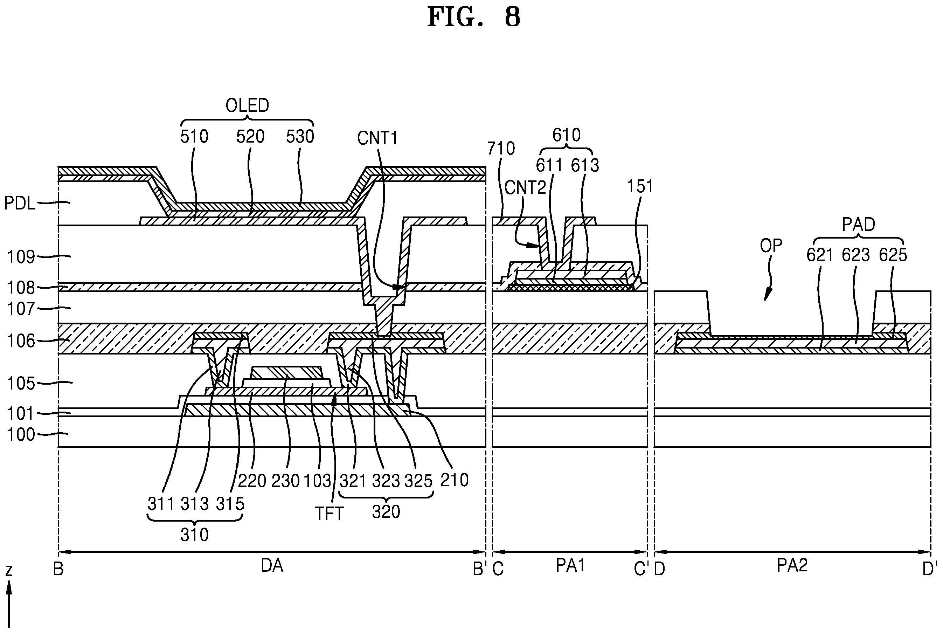

FIG. 8 is a schematic cross-sectional view of a display apparatus according to another embodiment. The display apparatus of FIG. 8 is similar to the display apparatus of FIG. 4B, but is different therefrom in that the pad PAD is in the same layer as the first source-drain electrode 310 and the second source-drain electrode 320. Hereinafter, descriptions regarding components that are the same as or similar to those already given are omitted, and a difference is mainly described.

According to one embodiment, a display apparatus 10 may include a transistor disposed above a substrate 100 and including a semiconductor layer 220, a gate electrode 230 overlapping the semiconductor layer 220 in a plan view, and at least one source-drain electrode 310, 320, a first inorganic insulating layer 106 may be disposed above the transistor, a first organic insulating layer 107 may be disposed above the first inorganic insulating layer 106, a power line 610 including a first molybdenum titanium (MoTi) layer 612 may be disposed above the first organic insulating layer 107 and a second conductive layer 613 may be disposed above the first molybdenum titanium (MoTi) layer 612, a second inorganic insulating layer 108 may be disposed above the power line 610, a second organic insulating layer 109 may be disposed above the second inorganic insulating layer 108, and a light-emitting diode may be disposed above the second organic insulating layer 109 and including a pixel electrode 510, an opposite electrode 530, and an intermediate layer 520 may be disposed between the pixel electrode 510 and the opposite electrode 530.

Referring to FIG. 8, in the display area DA, the organic light-emitting diode OLED and the thin-film transistor TFT electrically connected to the organic light-emitting diode OLED may be disposed above the substrate 100. The thin-film transistor TFT may include the semiconductor layer 220, the gate electrode 230, the first source-drain electrode 310, and the second source-drain electrode 320.

In the display area DA, the first source-drain electrode 310 and the second source-drain electrode 320 may be disposed above the interlayer-insulating layer 105. In an embodiment, the semiconductor layer 220 of the thin-film transistor TFT may be connected to a semiconductor layer 220 of another adjacent thin-film transistor TFT, and any one of the first source-drain electrode 310 and the second source-drain electrode 320 may be omitted.

The first source-drain electrode 310 and the second source-drain electrode 320 may each have a multilayered structure. The first source-drain electrode 310 may include the first sub-layer 311, the second sub-layer 313, and a fifth sub-layer 315, and the second source-drain electrode 320 may include the third sub-layer 321, the fourth sub-layer 323, and a sixth sub-layer 325. The first sub-layer 311 may include the same material as the third sub-layer 321. In an embodiment, the first sub-layer 311 and the third sub-layer 321 may each include Ti. The second sub-layer 313 may include the same material as the fourth sub-layer 323. In an embodiment, the second sub-layer 313 and the fourth sub-layer 323 may each include Al or Cu. The fifth sub-layer 315 may include the same material as the sixth sub-layer 325. In an embodiment, the fifth sub-layer 315 and the sixth sub-layer 325 may each include metal oxide. In an embodiment, for example, the metal oxide may include ITO.

In the second peripheral area PA2, the pad PAD may be disposed above the interlayer-insulating layer 105. The pad PAD may include the fourth conductive layer 621, the fifth conductive layer 623, and the sixth conductive layer 625 which are sequentially stacked. The fourth conductive layer 621, the fifth conductive layer 623, and the sixth conductive layer 625 may include different materials. The fourth conductive layer 621 may include Ti, the fifth conductive layer 623 may include Al or Cu, and the sixth conductive layer 625 may include metal oxide. Here, the metal oxide may include ITO.

In an embodiment, the fourth conductive layer 621 may include the same material as the first sub-layer 311 and the third sub-layer 321, the fifth conductive layer 623 may include the same material as the second sub-layer 313 and the fourth sub-layer 323, and the sixth conductive layer 625 may include the same material as the fifth sub-layer 315 and the sixth sub-layer 325.

The first inorganic insulating layer 106 may be disposed to cover the first source-drain electrode 310, the second source-drain electrode 320, and the pad PAD. The first inorganic insulating layer 106 may include silicon oxide, silicon nitride, and/or silicon oxynitride.

The first organic insulating layer 107 may be disposed above the first inorganic insulating layer 106. The first organic insulating layer 107 may function as a planarization layer to provide a flat upper surface by burying uneven portions formed because of the thin-film transistor TFT. The first organic insulating layer 107 may include an organic insulating material.

The first inorganic insulating layer 106 may effectively prevent or reduce the damage to the first source-drain electrode 310, the second source-drain electrode 320, and the pad PAD, where the damage is caused by gases, etc. generated from the first organic insulating layer 107 during the manufacturing of the display apparatus.

In the second peripheral area PA2, the opening OP may be arranged to overlap the pad PAD. The opening OP may be defined by the first inorganic insulating layer 106 and the first organic insulating layer 107 to expose the upper surface of the pad PAD. As described above with reference to FIG. 7, the sixth conductive layer 625 of the pad PAD may define the second groove 625GR that is formed as a portion of the sixth conductive layer 625 is etched during the process of forming the opening OP.

In the first peripheral area PA1, the power line 610 may be disposed above the first organic insulating layer 107. As described above, the power line 610 may be the common power voltage (ELVSS, see FIG.2) supply line or the driving power voltage (ELVDD, see FIG. 2) supply line.

The power line 610 may include the first conductive layer 611 and the second conductive layer 613 which are sequentially stacked. The first conductive layer 611 and the second conductive layer 613 may have different conductive materials. The first conductive layer 611 may include Ti, and the second conductive layer 613 may include Al and/or Cu.

The first protective layer 151 may be disposed between the power line 610 and the first organic insulating layer 107. The first protective layer 151 may include an inorganic insulating material, such as silicon oxide, silicon nitride, and/or silicon oxynitride. The first protective layer 151 may be formed through CVD.

In a plan view, the shape of the first protective layer 151 may correspond to the shape of the power line 610. In other words, the first protective layer 151 may be patterned together with the power line 610 through the same mask process.

The second inorganic insulating layer 108 may be disposed above the first organic insulating layer 107 to cover the power line 610. The second inorganic insulating layer 108 may include silicon oxide, silicon nitride, and/or silicon oxynitride.

The second organic insulating layer 109 may be disposed above the second inorganic insulating layer 108. The second organic insulating layer 109 may function as a planarization layer to provide a flat upper surface to the organic light-emitting diode OLED. The second organic insulating layer 109 may include an organic insulating material.

In an embodiment, the second inorganic insulating layer 108 may directly contact the first protective layer 151. In an embodiment, for example, the power line 610 may be separated from the first organic insulating layer 107 and the second organic insulating layer 109 by the first protective layer 151 and the second inorganic insulating layer 108.

In the display area DA, the organic light-emitting diode OLED may be disposed above the second organic insulating layer 109. The organic light-emitting diode OLED may include, for example, the pixel electrode 510, the opposite electrode 530, and the intermediate layer 520 arranged therebetween and including an emission layer.

The pixel electrode 510 may contact the second source-drain electrode 320 through the first contact hole CNT1 penetrating the second organic insulating layer 109, the second inorganic insulating layer 108, the first organic insulating layer 107, and the first inorganic insulating layer 106 and may be electrically connected to the thin-film transistor TFT. In other words, the first contact hole CNT1 may be defined by the first inorganic insulating layer 106, the first organic insulating layer 107, the second inorganic insulating layer 108, and the second organic insulating layer 109.

As described above with reference to FIG. 5, the first contact hole CNT1 may have a step in which the width of the first contact hole CNT1 discontinuously changes in the first organic insulating layer 107 in a plan view. That is, the first contact hole CNT1 may include the first portion (hp1, see FIG. 5), which is defined by the second organic insulating layer 109, the second inorganic insulating layer 108, and the upper portion of the first organic insulating layer 107, and the second portion (hp2, see FIG. 5), which is defined by the lower portion of the first organic insulating layer 107 and the first inorganic insulating layer 106. The width of the first portion (hp1, see FIG. 5) of the first contact hole CNT1 may be different from the width of the second portion (hp2, see FIG. 5) of the first contact hole CNT1. In an embodiment, for example, the width of the first portion (hp1, see FIG. 5) of the first contact hole CNT1 may be greater than the width of the second portion (hp2, see FIG. 5) of the first contact hole CNT1 in a plan view.

In the first peripheral area PA1, a connection line 710 may be disposed above the second organic insulating layer 109. The connection line 710 may be a bridge line for electrically connecting the power line 610 to the organic light-emitting diode OLED or the thin-film transistor TFT which is in the display area DA. The connection line 710 may include the same material as the pixel electrode 510. In an embodiment, for example, when the pixel electrode 510 has a stack structure of ITO/Ag/ITO, the connection line 710 may also have the stack structure.

The connection line 710 may contact the power line 610 through the second contact hole CNT2 penetrating the second organic insulating layer 109 and the second inorganic insulating layer 108. The second contact hole CNT2 may be defined by the second inorganic insulating layer 108 and the second organic insulating layer 109.

In the display area DA, the pixel-defining layer PDL may be disposed above the second organic insulating layer 109. An encapsulation layer (not shown) may be disposed to cover the organic light-emitting diode OLED. The encapsulation layer (not shown) may include at least one inorganic encapsulation layer and at least one organic encapsulation layer. The encapsulation layer (not shown) may cover the display area DA and extend to part of the first peripheral area PA1 and the second peripheral area PA2 outside the display area DA.

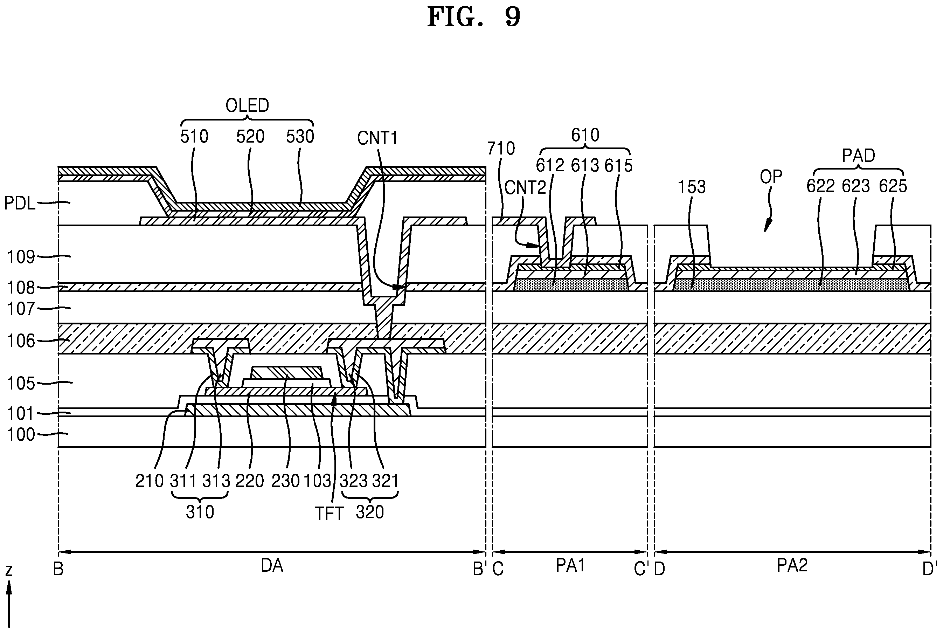

FIG. 9 is a schematic cross-sectional view of a display apparatus according to another embodiment. The display apparatus of FIG. 9 is similar to the display apparatus of FIG. 4B, but is different therefrom in that the power line 610 includes a MoTi layer instead of the first conductive layer (611, see FIG. 4B). Hereinafter, descriptions regarding components that are the same as or similar to those already given are omitted, and a difference is mainly described.

Referring to FIG. 9, in the display area DA, the organic light-emitting diode OLED and the thin-film transistor TFT electrically connected to the organic light-emitting diode OLED may be disposed above the substrate 100. The thin-film transistor TFT may include the semiconductor layer 220, the gate electrode 230, the first source-drain electrode 310, and the second source-drain electrode 320.

In the display area DA, the first source-drain electrode 310 and the second source-drain electrode 320 may be disposed above the interlayer-insulating layer 105. In an embodiment, the semiconductor layer 220 of the thin-film transistor TFT may be connected to a semiconductor layer 220 of another adjacent thin-film transistor TFT, and any one of the first source-drain electrode 310 and the second source-drain electrode 320 may be omitted.

The first inorganic insulating layer 106 may be disposed to cover the first source-drain electrode 310 and the second source-drain electrode 320. The first inorganic insulating layer 106 may include silicon oxide, silicon nitride, and/or silicon oxynitride.

The first organic insulating layer 107 may be disposed above the first inorganic insulating layer 106. The first organic insulating layer 107 may function as a planarization layer to provide a flat upper surface by burying uneven portions formed because of the thin-film transistor TFT. The first organic insulating layer 107 may include an organic insulating material.

In the first peripheral area PA1, the power line 610 may be disposed above the first organic insulating layer 107. As described above, the power line 610 may be the common power voltage (ELVSS, see FIG.2) supply line or the driving power voltage (ELVDD, see FIG. 2) supply line.

The power line 610 may include a first molybdenum titanium (MoTi) layer 612 and the second conductive layer 613 which are sequentially stacked. The first MoTi layer 612 may include MoTi. The second conductive layer 613 may include Al and/or Cu. The shape of the first MoTi layer 612 may correspond to the shape of the second conductive layer 613. According to one embodiment, the second inorganic insulating layer 108 may contact the first MoTi layer 612.

MoTi does not generate oxide, such as titanium oxide, even when heated at a temperature of 350 °C or higher. Therefore, the first MoTi layer 612 may effectively prevent or reduce the damage to the power line 610, where the damage is caused by gases, etc. generated from the first organic insulating layer 107 during the manufacture of the display apparatus.

In an embodiment, the power line 610 may further include the third conductive layer 615. The third conductive layer 615 may include metal oxide. In an embodiment, for example, the metal oxide may include ITO.

In the second peripheral area PA2, the pad PAD may be disposed above the first organic insulating layer 107. The pad PAD may include a second molybdenum titanium (MoTi) layer 622, the fifth conductive layer 623, and the sixth conductive layer 625 which are sequentially stacked, preferably between the first organic insulating layer 107 and the second inorganic insulating layer 108. The second MoTi layer 622 may include MoTi. The fifth conductive layer 623 may include Al or Cu, and the sixth conductive layer 625 may include metal oxide. Here, the metal oxide may include ITO. The shape of the second MoTi layer 622 may correspond to the shape of the fifth conductive layer 623 and the shape of the sixth conductive layer 625.

The second MoTi layer 622 may effectively prevent or reduce the damage to the pad PAD, where the damage is caused by gases, etc. generated from the first organic insulating layer 107 during the manufacture of the display apparatus.

In an embodiment, the second MoTi layer 622 may include the same material as the first MoTi layer 612. As described, the fifth conductive layer 623 may include the same material as the second conductive layer 613, and the sixth conductive layer 625 may include the same material as the third conductive layer 615.

The second inorganic insulating layer 108 may be disposed above the first organic insulating layer 107 to cover the power line 610 and the pad PAD. The second inorganic insulating layer 108 may include silicon oxide, silicon nitride, and/or silicon oxynitride.

The second organic insulating layer 109 may be disposed above the second inorganic insulating layer 108. The second organic insulating layer 109 may function as a planarization layer to provide a flat upper surface to the organic light-emitting diode OLED. The second organic insulating layer 109 may include an organic insulating material.

According to the invention the second inorganic insulating layer 108 may directly contact the first MoTi layer 612 and the second MoTi layer 622. Therefore, the second conductive layer 613 and the third conductive layer 615 of the power line 610 may be separated from the first organic insulating layer 107 and the second organic insulating layer 109 by the first MoTi layer 612 and the second inorganic insulating layer 108. As described, the fifth conductive layer 623 and the sixth conductive layer 625 of the pad PAD may be separated from the first organic insulating layer 107 and the second organic insulating layer 109 by the second MoTi layer 622 and the second inorganic insulating layer 108.

The opening OP may be arranged, wherein the opening OP overlaps the pad PAD and exposes the upper surface of the pad PAD from the second inorganic insulating layer 108 and the second organic insulating layer 109. The opening OP may be defined by the second inorganic insulating layer 108 and the second organic insulating layer 109. The pad PAD may be electrically connected to the integrated circuit device and/or the printed circuit board through the opening OP.

In the display area DA, the organic light-emitting diode OLED may be disposed above the second organic insulating layer 109. The organic light-emitting diode OLED may include, for example, the pixel electrode 510, the opposite electrode 530, and the intermediate layer 520 arranged therebetween and including an emission layer.

The pixel electrode 510 may contact the second source-drain electrode 320 through the first contact hole CNT1 penetrating the second organic insulating layer 109, the second inorganic insulating layer 108, the first organic insulating layer 107, and the first inorganic insulating layer 106 and may be electrically connected to the thin-film transistor TFT. In other words, the first contact hole CNT1 may be defined by the first inorganic insulating layer 106, the first organic insulating layer 107, the second inorganic insulating layer 108, and the second organic insulating layer 109.

As described above with reference to FIG. 5, the first contact hole CNT1 may have a step in which the width of the first contact hole CNT1 discontinuously changes in the first organic insulating layer 107. That is, the first contact hole CNT1 may include the first portion (hp1, see FIG. 5), which is defined by the second organic insulating layer 109, the second inorganic insulating layer 108, and the upper portion of the first organic insulating layer 107, and the second portion (hp2, see FIG. 5), which is defined by the lower portion of the first organic insulating layer 107 and the first inorganic insulating layer 106. The width of the first portion (hp1, see FIG. 5) of the first contact hole CNT1 may be different from the width of the second portion (hp2, see FIG. 5) of the first contact hole CNT1 in a plan view. In an embodiment, for example, the width of the first portion (hp1, see FIG. 5) of the first contact hole CNT1 may be greater than the width of the second portion (hp2, see FIG. 5) of the first contact hole CNT1.

In the first peripheral area PA1, the connection line 710 may be disposed above the second organic insulating layer 109. The connection line 710 may be a bridge line for electrically connecting the power line 610 to the organic light-emitting diode OLED or the thin-film transistor TFT which is in the display area DA. The connection line 710 may include the same material as the pixel electrode 510. In an embodiment, for example, when the pixel electrode 510 has a stack structure of ITO/Ag/ITO, the connection line 710 may also have the stack structure.

The connection line 710 may contact the power line 610 through the second contact hole CNT2 penetrating the second organic insulating layer 109 and the second inorganic insulating layer 108. The second contact hole CNT2 may be defined by the second inorganic insulating layer 108 and the second organic insulating layer 109.

In the display area DA, the pixel-defining layer PDL may be disposed above the second organic insulating layer 109. An encapsulation layer (not shown) may be disposed to cover the organic light-emitting diode OLED. The encapsulation layer (not shown) may include at least one inorganic encapsulation layer and at least one organic encapsulation layer. The encapsulation layer (not shown) may cover the display area DA and extend to part of the first peripheral area PA1 and the second peripheral area PA2 outside the display area DA.

FIGS. 10A to 10F are schematic cross-sectional views showing processes of manufacturing the display apparatus of FIG. 4B.

First of all, referring to FIG. 10A, the thin-film transistor TFT may be formed on the substrate 100. The thin-film transistor TFT may include the semiconductor layer 220, the gate electrode 230, the first source-drain electrode 310, and the second source-drain electrode 320.

The buffer layer 101 may be formed between the substrate 100 and the semiconductor layer 220, and the gate insulating layer 103 may be formed between the semiconductor layer 220 and the gate electrode 230. The interlayer-insulating layer 105 may be formed between the gate electrode 230 and the first source-drain electrode 310 and the second source-drain electrode 320. The buffer layer 101, the gate insulating layer 103, and the interlayer-insulating layer 105 may each include an inorganic insulating material, such as silicon oxide, silicon nitride, and/or silicon oxynitride, and have a single-layer structure or a multilayered structure including the above material.

The lower metal layer 210 may be formed between the substrate 100 and the semiconductor layer 220. In an embodiment, for example, the lower metal layer 210 may be disposed between the substrate 100 and the buffer layer 101. In an embodiment, the second source-drain electrode 320 may contact the lower metal layer 210 through a contact hole penetrating the interlayer-insulating layer 105 and the buffer layer 101.

The first source-drain electrode 310 and the second source-drain electrode 320 may each have a multilayered structure. The first source-drain electrode 310 may include the first sub-layer 311 and the second sub-layer 313, and the second source-drain electrode 320 may include the third sub-layer 321 and the fourth sub-layer 323. The first sub-layer 311 and the third sub-layer 321 may be formed through the same deposition process. Likewise, the second sub-layer 313 and the fourth sub-layer 323 may be formed through the same deposition process.

The first inorganic insulating layer 106 and the first organic insulating layer 107 may be sequentially formed on the entire substrate 100 to cover the first source-drain electrode 310 and the second source-drain electrode 320. The first inorganic insulating layer 106 may include silicon oxide, silicon nitride, and/or silicon oxynitride. The first organic insulating layer 107 may include an organic insulating material.

According to an embodiment, the forming of the first contact hole CNT1 may comprise forming, in the plan view, a sub-hole overlapping the previous contact hole and penetrating the second organic insulating layer 109; and forming, through the sub-hole, a first portion hp1 of the first contact hole CNT1 and a second portion hp2 of the first contact hole CNT1, and the first portion hp1 of the first contact hole CNT1 is defined by the second organic insulating layer 109, the second inorganic insulating layer 108, and an upper portion of the first organic insulating layer 107, and the second portion hp2 of the first contact hole CNT1 may be defined by the first inorganic insulating layer 106 and a lower portion of the first organic insulating layer 107.

According to an embodiment, at a border between the first portion hp1 and the second portion hp2, the first portion hp1 may have a first width w1, and the second portion hp2 may have a second width w2 that is less than the first width w1 in the plan view.

A previous contact hole pCNT1 is formed to overlap the second source-drain electrode 320 in a plan view. The previous contact hole pCNT1 may include a previous sub-hole 107hp and a third groove 106GR. The previous sub-hole 107hp may be defined through the first organic insulating layer 107, and the third groove 106GR may be defined on the first inorganic insulating layer 106. The third groove 106GR may be formed as a portion (i.e., upper portion) of the first inorganic insulating layer 106 is etched through the previous sub-hole 107hp. That is, the first inorganic insulating layer 106 may not be fully etched through the previous sub-hole 107hp, and at least a portion (i.e., lower portion) of the first inorganic insulating layer 106 may remain such that the first inorganic insulating layer 106 may still cover the upper surface of the second source-drain electrode 320. The thickness of the remaining portion of the first inorganic insulating layer 106, which overlaps the third groove 106GR, may be between about 300 angstroms (Å) and about 5000 Å. Therefore, the damage to the upper surface of the second source-drain electrode 320 during subsequent processes may be effectively prevented or reduced.

Then, an inorganic insulating layer may be formed on the first organic insulating layer 107 through CVD. The inorganic insulating layer may include silicon oxide, silicon nitride, and/or silicon oxynitride. Next, a first conductive layer and a second conductive layer, which include different conductive materials, may be sequentially formed. In an embodiment, for example, the first conductive layer may include Ti, and the second conductive layer may include Al and/or Cu. A third conductive layer may be formed on the second conductive layer. The third conductive layer may include metal oxide. In an embodiment, for example, the metal oxide may include ITO. The first conductive layer, the second conductive layer, the third conductive layer, and the inorganic insulating layer may be formed on the entirety of the substrate 100.

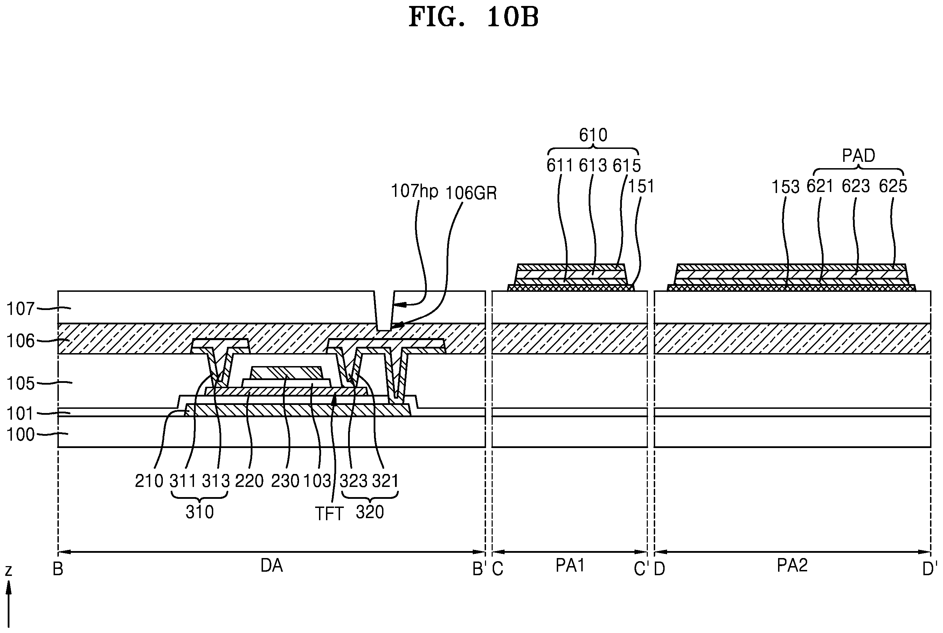

The first conductive layer, the second conductive layer, the third conductive layer, and the inorganic insulating layer may be patterned through the same mask process. As shown in FIG. 10B, the first conductive layer may be patterned, and thus, the first conductive layer 611 of the power line 610 and the fourth conductive layer 621 of the pad PAD may be formed in the first and second peripheral areas PA1 and PA2. The second conductive layer may be patterned, and thus, the second conductive layer 613 of the power line 610 and the fifth conductive layer 623 of the pad PAD may be formed. The third conductive layer may be patterned, and thus, the third conductive layer 615 of the power line 610 and the sixth conductive layer 625 of the pad PAD may be formed. The third conductive layer 615 may include the same material as the sixth conductive layer 625. The inorganic insulating layer may be patterned, and thus, the first protective layer 151 and the second protective layer 153 may be formed.

According to an embodiment, the forming of the power line 610, the first protective layer 151, the first conductive layer 611, and the second conductive layer 613 may be patterned through a same mask process. According to a further embodiment, on the first organic insulating layer 107, a pad comprising a second protective layer 153 comprising an inorganic insulating material, and a fourth conductive layer 621, a fifth conductive layer 623, and a sixth conductive layer 625 may be formed, which are sequentially stacked on the second protective layer 153, and the second protective layer 153, the fourth conductive layer 621, the fifth conductive layer 623, and the sixth conductive layer 625 are patterned through a same mask process. According to a further embodiment, a third conductive layer 615 may be formed on the second conductive layer (613), and the third conductive layer 615 may comprise a same material as the sixth conductive layer 625.

That is, the first protective layer 151, the first conductive layer 611, the second conductive layer 613, and the third conductive layer 615 may be patterned through the same mask process. Therefore, the shape of the first protective layer 151 may correspond to the shape of the power line 610. Likewise, the second protective layer 153, the fourth conductive layer 621, the fifth conductive layer 623, and the sixth conductive layer 625 may be patterned through the same mask process. Therefore, the shape of the second protective layer 153 may correspond to the shape of the pad PAD.

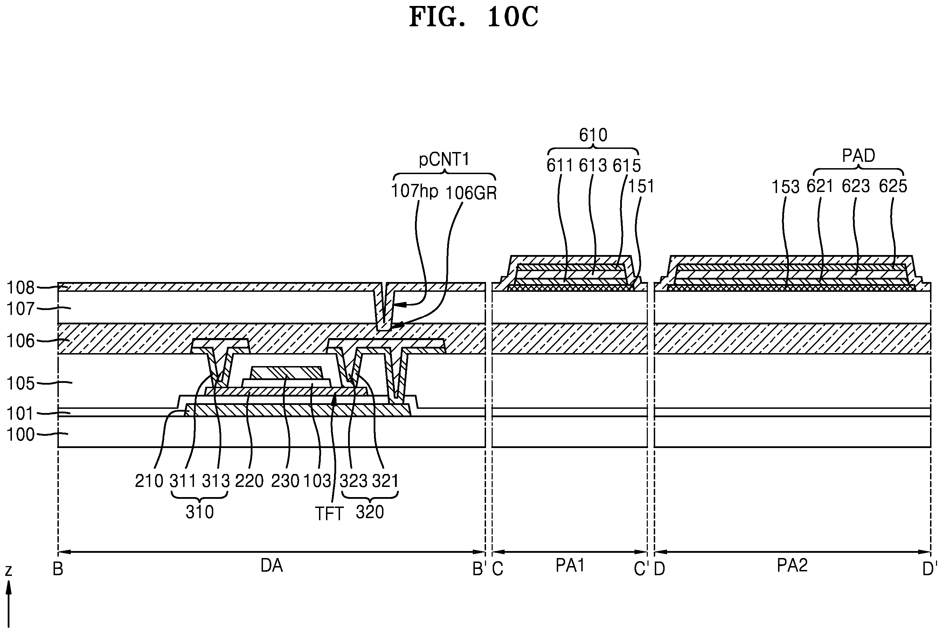

Referring to FIG. 10C, the second inorganic insulating layer 108 may be formed to cover the power line 610 and the pad PAD. The second inorganic insulating layer 108 may include silicon oxide, silicon nitride, and/or silicon oxynitride. The second inorganic insulating layer 108 may be deposited on the entire substrate 100. The second inorganic insulating layer 108 may directly contact the first inorganic insulating layer 106 through the previous contact hole pCNT1. Since the first inorganic insulating layer 106 remains on the upper surface of the second source-drain electrode 320, the damage to the upper surface of the second source-drain electrode 320 may be effectively prevented or reduced during the patterning process of first protective layer 151 and the second protective layer 153. According to one embodiment, in the sequentially forming of the second inorganic insulating layer 108 and the second organic insulating layer 109, the second inorganic insulating layer 108 may contact the first inorganic insulating layer 106 through the previous contact hole pCNT1.

The second inorganic insulating layer 108 may directly contact the first protective layer 151 and seal the power line 610 with the first protective layer 151. Likewise, the second inorganic insulating layer 108 may directly contact the second protective layer 153 and seal the pad PAD with the second protective layer 153.

Referring to FIG. 10D, the second organic insulating layer 109 may be formed on the structure described with reference to FIG. 10C. The second organic insulating layer 109 may include an organic insulating material.

In the display area DA, the fourth sub-hole 109h1 may be formed to overlap the second source-drain electrode 320 and the previous contact hole pCNT1 in a plan view. In the first peripheral area PA1, the sixth sub-hole 109h2 may be formed to overlap the power line 610 in a plan view. In the second peripheral area PA2, the second sub-opening 109OP may be formed to overlap the pad PAD in a plan view. The fourth sub-hole 109h1, the sixth sub-hole 109h2, and the second sub-opening 109OP may be defined by the second organic insulating layer 109 by penetrating the second organic insulating layer 109 to expose the upper surface of the second inorganic insulating layer 108.

Referring to FIG. 10E, the second inorganic insulating layer 108, the first organic insulating layer 107, and the first inorganic insulating layer 106 may be etched through the fourth sub-hole 109h1, the sixth sub-hole 109h2, and the second sub-opening 109OP.

In the display area DA, the second inorganic insulating layer 108, and the remaining lower portion of the first inorganic insulating layer 106 may be further etched through the fourth sub-hole 109h1, and thus, the first contact hole CNT1 may be formed, where the first contact hole CNT1 penetrates the second organic insulating layer 109, the second inorganic insulating layer 108, the first organic insulating layer 107, and the first inorganic insulating layer 106. In other words, the first sub-hole 106h, the second sub-hole 107h, the third sub-hole 108h1, and the fourth sub-hole 109h1, which overlap each other, may form the first contact hole CNT1.

The first contact hole CNT1 may include the first portion hp1, which is defined by the second organic insulating layer 109, the second inorganic insulating layer 108, and the upper portion of the first organic insulating layer 107, and the second portion hp2, which is defined by the lower portion of the first organic insulating layer 107 and the first inorganic insulating layer 106. The width of the first portion hp1 of the first contact hole CNT1 may be different from the width of the second portion hp2 of the first contact hole CNT1. In an embodiment, for example, the width of the first portion hp1 of the first contact hole CNT1 may be greater than the width of the second portion hp2 of the first contact hole CNT1 in a plan view.

As the first contact hole CNT1 is formed through multiple deposition processes, the erosion of the upper surface of the fourth sub-layer 323 of the second source-drain electrode 320 may be prevented or reduced. Also, during the manufacture of the display apparatus, the exposure of the upper surface of the fourth sub-layer 323 of the second source-drain electrode 320 may be reduced, and thus, the damage to the fourth sub-layer 323 by gases, etc. generated from the first organic insulating layer 107 may be effectively prevented or reduced.

In the first peripheral area PA1, the second inorganic insulating layer 108 may be etched through the sixth sub-hole 109h2, and thus, the second contact hole CNT2 penetrating the second inorganic insulating layer 108 and the second organic insulating layer 109 may be formed. In other words, the fifth sub-hole 108h2 and the sixth sub-hole 109h2, which overlap each other, may form the second contact hole CNT2. In the process of forming the second contact hole CNT2, a portion of the third conductive layer 615 of the power line 610 may also be removed. As described above with reference to FIG. 6, the third conductive layer 615 may define the first groove (615GR, see FIG. 6) overlapping the second contact hole CNT2. The third conductive layer 615 may effectively prevent or reduce the damage to the power line 610 while the second contact hole CNT2 is formed.

In the second peripheral area PA2, the opening OP penetrating the second inorganic insulating layer 108 and the second organic insulating layer 109 may be formed by etching the second inorganic insulating layer 108 through the second sub-opening 109OP. The first sub-opening 108OP and the second sub-opening 109OP, which overlap each other, may form the opening OP. In the process of forming the opening OP, a portion of the sixth conductive layer 625 of the pad PAD may also be removed. As described above with reference to FIG. 7, the sixth conductive layer 625 may define the second groove (625GR, see FIG. 7) overlapping the opening OP. The sixth conductive layer 625 may effectively prevent or reduce the damage to the pad PAD in the process of forming the opening OP.

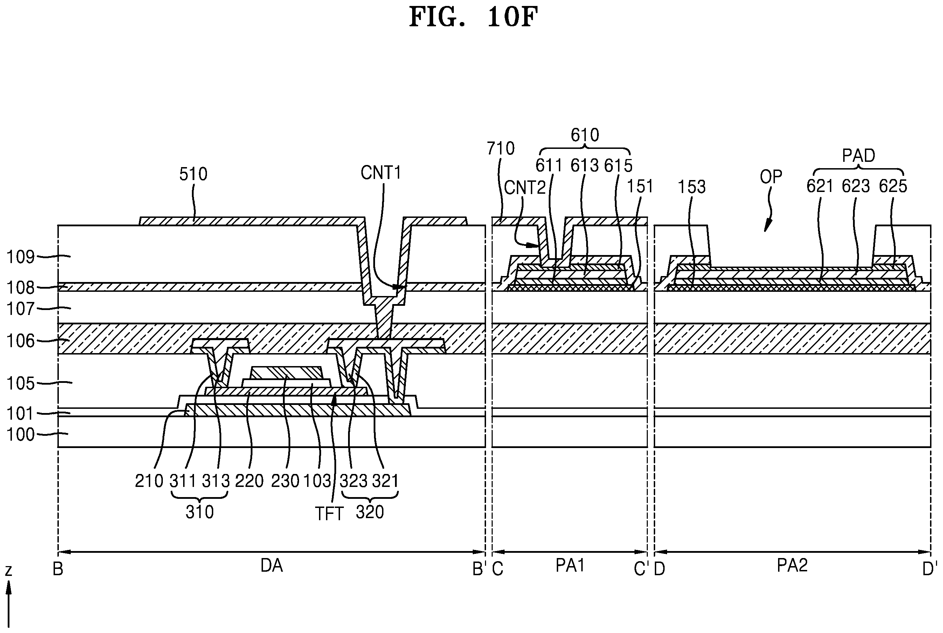

Referring to FIG. 10F, the pixel electrode 510 and the connection line 710 may be formed on the structure described with reference to FIG. 10E. The pixel electrode 510 may contact the second source-drain electrode 320 through the first contact hole CNT1. The connection line 710 may contact the power line 610 through the second contact hole CNT2.

According to a display apparatus and a method of manufacturing the same according to the one or more embodiments, the first source-drain electrode 310 and the second source-drain electrode 320 are arranged on a different layer from the power line 610, and thus, a high-resolution display apparatus may be realized. Also, as the power line 610 is separated from the first organic insulating layer 107 and the second organic insulating layer 109 by the first protective layer 151 and the second inorganic insulating layer 108, the damage to the power line 610 may be effectively prevented or reduced without an additional process, such as a preheating process.

According to the one or more embodiments, a display apparatus with a low occurrence rate of defects during manufacturing and a method of manufacturing the same may be realized. However, the scope of the disclosure is not limited by the effects.

It should be understood that embodiments described herein should be considered in a descriptive sense only and not for purposes of limitation. Descriptions of features or aspects within each embodiment should typically be considered as available for other similar features or aspects in other embodiments.

## Claims

1. A display apparatus (10) comprising:
a transistor disposed above a substrate (100) and comprising a semiconductor layer (220), a gate electrode (230) overlapping the semiconductor layer (220), and a source-drain electrode (320);
a first inorganic insulating layer (106) disposed above the transistor;
a first organic insulating layer (107) disposed above the first inorganic insulating layer (106);
a power line (610) disposed above the first organic insulating layer (107) and comprising a first conductive layer (611) and a second conductive layer (613) on the first conductive layer (611);
a first protective layer (151) comprising an inorganic insulating material, disposed between the first organic insulating layer (107) and the power line (610) and having a shape corresponding to a shape of the power line (610) in a plan view;
a second inorganic insulating layer (108) disposed above the power line (610);
a second organic insulating layer (109) disposed above the second inorganic insulating layer (108); and
a light-emitting diode disposed above the second organic insulating layer (109) and comprising a pixel electrode (510), an opposite electrode (530), and an intermediate layer (520) disposed between the pixel electrode (510) and the opposite electrode (530),
wherein the second inorganic insulating layer (108) directly contacts the first protective layer (151), and the power line (610) is separated from the first organic insulating layer (107) and the second organic insulating layer (109) by the first protective layer (151) and the second inorganic insulating layer (108).

2. The display apparatus (10) of claim 1, wherein the pixel electrode (510) is electrically connected to the source-drain electrode (320) through a first contact hole (CNT1),
the first contact hole (CNT1) comprises a first portion (hp1), which is defined by the second organic insulating layer (109), the second inorganic insulating layer (108), and an upper portion of the first organic insulating layer (107), and a second portion (hp2), which is defined by the first inorganic insulating layer (106) and a lower portion of the first organic insulating layer (107), and
at a border between the first portion (hp1) and the second portion (hp2), the first portion (hp1) has a first width (w1), and the second portion (hp2) has a second width (w2) that is less than the first width (w1) in the plan view.

3. The display apparatus (10) of claim 2, wherein the border between the first portion (hp1) and the second portion (hp2) is located between an upper surface (107us) and a lower surface (170bs) of the first organic insulating layer (107).

4. The display apparatus (10) of any one of claims 1 to 3, further comprising:
a pad (PAD) comprising a fourth conductive layer (621), a fifth conductive layer (623), and a sixth conductive layer (625), which are sequentially stacked between the first organic insulating layer (107) and the second inorganic insulating layer (108); and
a second protective layer (153) disposed between the first organic insulating layer (107) and the pad (PAD) and having a shape corresponding to a shape of the pad (PAD) in the plan view,
wherein the sixth conductive layer (625) comprises metal oxide.

5. The display apparatus (10) of any one of claims 1 to 4, further comprising a pad opening defined by the second inorganic insulating layer (108) and the second organic insulating layer (109) and overlapping the pad (PAD) in the plan view.

6. The display apparatus (10) of claim 4 or 5, wherein the power line (610) further comprises a third conductive layer (615) disposed between the second conductive layer (613) and the second inorganic insulating layer (108), and
the sixth conductive layer (625) comprises a same material as the third conductive layer (615).

7. The display apparatus (10) of any of claims 1 to 6, further comprising:
a pad (PAD) disposed between the substrate (100) and the first inorganic insulating layer (106) and comprising a fourth conductive layer (621), a fifth conductive layer (623), and a sixth conductive layer (625), which are sequentially stacked; and
a pad opening defined by the first inorganic insulating layer (106) and the first organic insulating layer (107) and overlapping the pad (PAD) in the plan view,
wherein the sixth conductive layer (625) comprises metal oxide.

8. The display apparatus (10) of claim 7, wherein the source-drain electrode (320) comprises a first sub-layer (311), a second sub-layer (313), and a third sub-layer (321), which are sequentially stacked, and
the sixth conductive layer (625) comprises a same material as the third sub-layer (321).

9. A display apparatus (10) comprising:
a transistor disposed above a substrate (100) and comprising a semiconductor layer (220), a gate electrode (230) overlapping the semiconductor layer (220) in a plan view, and a source-drain electrode (320);
a first inorganic insulating layer (106) disposed above the transistor;
a first organic insulating layer (107) disposed above the first inorganic insulating layer (106);
a power line (610) comprising a first molybdenum titanium (MoTi) layer (612) disposed above the first organic insulating layer (107) and a second conductive layer (613) disposed above the first molybdenum titanium (MoTi) layer (612);
a second inorganic insulating layer (108) disposed above the power line (610);
a second organic insulating layer (109) disposed above the second inorganic insulating layer (108); and
a light-emitting diode disposed above the second organic insulating layer (109) and comprising a pixel electrode (510), an opposite electrode (530), and an intermediate layer (520) disposed between the pixel electrode (510) and the opposite electrode (530),
wherein the second inorganic insulating layer (108) directly contacts the first molybdenum titanium (MoTi) layer (612), and second conductive layer (613) is separated from the first organic insulating layer (107) and the second organic insulating layer (109) by the first molybdenum titanium (MoTi) layer (612) and the second inorganic insulating layer (108).

10. The display apparatus (10) of claim 9, wherein, in the plan view, a shape of the first molybdenum titanium (MoTi) layer (612) corresponds to a shape of the second conductive layer (613), and
the second inorganic insulating layer (108) contacts the first molybdenum titanium (MoTi) layer (612).

11. The display apparatus (10) of claim 9, further comprising:
a pad (PAD) comprising a second molybdenum titanium layer (622), a fifth conductive layer (623), and a sixth conductive layer (625), which are sequentially stacked between the first organic insulating layer (107) and the second inorganic insulating layer (108),
wherein the sixth conductive layer (625) comprises metal oxide.

12. The display apparatus (10) of claim 9, wherein the pixel electrode (510) is electrically connected to the at least one source-drain electrode (310, 320) through a first contact hole (CNT1),
the first contact hole (CNT1) comprises a first portion (hp1), which is defined by the second organic insulating layer (109), the second inorganic insulating layer (108), and an upper portion of the first organic insulating layer (107), and a second portion (hp2), which is defined by the first inorganic insulating layer (106) and a lower portion of the first organic insulating layer (107), and
at a border between the first portion (hp1) and the second portion (hp2), the first portion (hp1) has a first width (w1), and the second portion (hp2) has a second width (w2) that is less than the first width (w1) in the plan view.

13. A method of manufacturing a display apparatus (10), the method comprising:
forming, on a substrate (100), a transistor comprising a semiconductor layer (220), a gate electrode (230) overlapping the semiconductor layer (220) in a plan view, and a source-drain electrode (320);
sequentially forming, on the transistor, a first inorganic insulating layer (106) and a first organic insulating layer (107) and forming a previous contact hole (pCNT1) by removing a first portion of the first inorganic insulating layer (106) and a portion of the first organic insulating layer (107);
forming, on the first organic insulating layer (107), a power line (610) comprising a first protective layer (151) comprising an inorganic insulating material, a first conductive layer (611) disposed above the first protective layer (151), and a second conductive layer (613) disposed above the first conductive layer (611);
sequentially forming, on the power line (610), a second inorganic insulating layer (108) and a second organic insulating layer (109);
forming a first contact hole (CNT1) by removing a second portion of the first inorganic insulating layer (106), a portion of the second inorganic insulating layer (108), and a portion of the second organic insulating layer (109); and
forming, on the second organic insulating layer (109), a light-emitting diode comprising a pixel electrode (510), an opposite electrode (530), and an intermediate layer (520) disposed between the pixel electrode (510) and the opposite electrode (530),
wherein, the previous contact hole (pCNT1) is formed to overlap the second source-drain electrode (320) in a plan view,
wherein the second portion of the first inorganic insulating layer (106), the portion of the second inorganic insulating layer (108), and the portion of the second organic insulating layer (109) overlap the previous contact hole (pCNT1) in the plan view.

14. The method of claim 13, wherein the forming of the previous contact hole (pCNT1) comprises:
forming a previous-sub hole (107hp) penetrating the first organic insulating layer (107); and
forming a groove (106GR) by removing the first portion of the first inorganic insulating layer (106) through the previous-sub hole (107hp).

## Patentansprüche

1. Anzeigevorrichtung (10), umfassend:
einen Transistor, der über einem Substrat (100) angeordnet ist und eine Halbleiterschicht (220), eine die Halbleiterschicht (220) überlappende Gate-Elektrode (230) und eine Source-Drain-Elektrode (320) umfasst;
eine erste anorganische Isolierschicht (106), die über dem Transistor angeordnet ist;
eine erste organische Isolierschicht (107), die über der ersten anorganischen Isolierschicht (106) angeordnet ist;
eine Stromleitung (610), die über der ersten organischen Isolierschicht (107) angeordnet ist und eine erste leitfähige Schicht (611) und eine zweite leitfähige Schicht (613) auf der ersten leitfähigen Schicht (611) umfasst;
eine erste Schutzschicht (151), die ein anorganisches Isoliermaterial umfasst, zwischen der ersten organischen Isolierschicht (107) und der Stromleitung (610) angeordnet ist und eine Form aufweist, die einer Form der Stromleitung (610) in der Draufsicht entspricht;
eine zweite anorganische Isolierschicht (108), die über der Stromleitung (610) angeordnet ist;
eine zweite organische Isolierschicht (109), die über der zweiten anorganischen Isolierschicht (108) angeordnet ist; und
eine Leuchtdiode, die über der zweiten organischen Isolierschicht (109) angeordnet ist und eine Pixelelektrode (510), eine Gegenelektrode (530) und eine zwischen der Pixelelektrode (510) und der Gegenelektrode (530) angeordnete Zwischenschicht (520) umfasst,
wobei die zweite anorganische Isolierschicht (108) in direktem Kontakt mit der ersten Schutzschicht (151) steht und die Stromleitung (610) durch die erste Schutzschicht (151) und die zweite anorganische Isolierschicht (108) von der ersten organischen Isolierschicht (107) und der zweiten organischen Isolierschicht (109) getrennt ist.

2. Anzeigevorrichtung (10) nach Anspruch 1, wobei die Pixelelektrode (510) über ein erstes Kontaktloch (CNT1) elektrisch mit der Source-Drain-Elektrode (320) verbunden ist,
das erste Kontaktloch (CNT1) einen ersten Abschnitt (hp1), der durch die zweite organische Isolierschicht (109), die zweite anorganische Isolierschicht (108) und einen oberen Abschnitt der ersten organischen Isolierschicht (107) definiert ist, und einen zweiten Abschnitt (hp2) umfasst, der durch die erste anorganische Isolierschicht (106) und einen unteren Abschnitt der ersten organischen Isolierschicht (107) definiert ist, und
an einer Grenze zwischen dem ersten Abschnitt (hp1) und dem zweiten Abschnitt (hp2) der erste Abschnitt (hp1) eine erste Breite (w1) und der zweite Abschnitt (hp2) eine zweite Breite (w2), die in der Draufsicht kleiner ist als die erste Breite (w1), aufweist.

3. Anzeigevorrichtung (10) nach Anspruch 2, wobei sich die Grenze zwischen dem ersten Abschnitt (hp1) und dem zweiten Abschnitt (hp2) zwischen einer oberen Oberfläche (107us) und einer unteren Oberfläche (170bs) der ersten organischen Isolierschicht (107) befindet.

4. Anzeigevorrichtung (10) nach einem der Ansprüche 1 bis 3, umfassend ferner:
ein Pad (PAD), das eine vierte leitfähige Schicht (621), eine fünfte leitfähige Schicht (623) und eine sechste leitfähige Schicht (625) umfasst, die nacheinander zwischen der ersten organischen Isolierschicht (107) und der zweiten anorganischen Isolierschicht (108) gestapelt sind; und
eine zweite Schutzschicht (153), die zwischen der ersten organischen Isolierschicht (107) und dem Pad (PAD) angeordnet ist und eine Form aufweist, die einer Form des Pads (PAD) in der Draufsicht entspricht,
wobei die sechste leitfähige Schicht (625) Metalloxid umfasst.

5. Anzeigevorrichtung (10) nach einem der Ansprüche 1 bis 4, umfassend ferner eine Pad-Öffnung, die durch die zweite anorganische Isolierschicht (108) und die zweite organische Isolierschicht (109) definiert ist und das Pad (PAD) in der Draufsicht überlappt.

6. Anzeigevorrichtung (10) nach Anspruch 4 oder 5, wobei die Stromleitung (610) ferner eine dritte leitfähige Schicht (615) umfasst, die zwischen der zweiten leitfähigen Schicht (613) und der zweiten anorganischen Isolierschicht (108) angeordnet ist, und
die sechste leitfähige Schicht (625) das gleiche Material wie die dritte leitfähige Schicht (615) umfasst.

7. Anzeigevorrichtung (10) nach einem der Ansprüche 1 bis 6, umfassend ferner:
ein Pad (PAD), das zwischen dem Substrat (100) und der ersten anorganischen Isolierschicht (106) angeordnet ist und eine vierte leitfähige Schicht (621), eine fünfte leitfähige Schicht (623) und eine sechste leitfähige Schicht (625) umfasst, die nacheinander gestapelt sind; und
eine Pad-Öffnung, die durch die erste anorganische Isolierschicht (106) und die erste organische Isolierschicht (107) definiert ist und das Pad (PAD) in der Draufsicht überlappt,
wobei die sechste leitfähige Schicht (625) Metalloxid umfasst.

8. Anzeigevorrichtung (10) nach Anspruch 7, wobei die Source-Drain-Elektrode (320) eine erste Unterschicht (311), eine zweite Unterschicht (313) und eine dritte Unterschicht (321) umfasst, die nacheinander gestapelt sind, und
die sechste leitfähige Schicht (625) das gleiche Material wie die dritte Unterschicht (321) umfasst.

9. Anzeigevorrichtung (10), umfassend:
einen Transistor, der über einem Substrat (100) angeordnet ist und eine Halbleiterschicht (220), eine Gate-Elektrode (230), die in der Draufsicht die Halbleiterschicht (220) überlappt, und eine Source-Drain-Elektrode (320) umfasst;
eine erste anorganische Isolierschicht (106), die über dem Transistor angeordnet ist;
eine erste organische Isolierschicht (107), die über der ersten anorganischen Isolierschicht (106) angeordnet ist;
eine Stromleitung (610), die eine erste Molybdän-Titan-(MoTi)-Schicht (612), die über der ersten organischen Isolierschicht (107) angeordnet ist, und eine zweite leitfähige Schicht (613) umfasst, die über der ersten Molybdän-Titan-(MoTi)-Schicht (612) angeordnet ist;
eine zweite anorganische Isolierschicht (108), die über der Stromleitung (610) angeordnet ist;
eine zweite organische Isolierschicht (109), die über der zweiten anorganischen Isolierschicht (108) angeordnet ist; und
eine Leuchtdiode, die über der zweiten organischen Isolierschicht (109) angeordnet ist und eine Pixelelektrode (510), eine Gegenelektrode (530) und eine zwischen der Pixelelektrode (510) und der Gegenelektrode (530) angeordnete Zwischenschicht (520) umfasst,
wobei die zweite anorganische Isolierschicht (108) in direktem Kontakt mit der ersten Molybdän-Titan-(MoTi)-Schicht (612) steht und die zweite leitfähige Schicht (613) durch die erste Molybdän-Titan-(MoTi)-Schicht (612) und die zweite anorganische Isolierschicht (108) von der ersten organischen Isolierschicht (107) und der zweiten organischen Isolierschicht (109) getrennt ist.

10. Anzeigevorrichtung (10) nach Anspruch 9, wobei in der Draufsicht eine Form der ersten Molybdän-Titan-(MoTi)-Schicht (612) einer Form der zweiten leitfähigen Schicht (613) entspricht und
die zweite anorganische Isolierschicht (108) die erste Molybdän-Titan-(MoTi)-Schicht (612) berührt.

11. Anzeigevorrichtung (10) nach Anspruch 9, umfassend ferner:
ein Pad (PAD), das eine zweite Molybdän-Titan-Schicht (622), eine fünfte leitfähige Schicht (623) und eine sechste leitfähige Schicht (625) umfasst, die nacheinander zwischen der ersten organischen Isolierschicht (107) und der zweiten anorganischen Isolierschicht (108) gestapelt sind,
wobei die sechste leitfähige Schicht (625) Metalloxid umfasst.

12. Anzeigevorrichtung (10) nach Anspruch 9, wobei die Pixelelektrode (510) über ein erstes Kontaktloch (CNT1) elektrisch mit der mindestens einen Source-Drain-Elektrode (310, 320) verbunden ist,
das erste Kontaktloch (CNT1) einen ersten Abschnitt (hp1), der durch die zweite organische Isolierschicht (109), die zweite anorganische Isolierschicht (108) und einen oberen Abschnitt der ersten organischen Isolierschicht (107) definiert ist, und einen zweiten Abschnitt (hp2) umfasst, der durch die erste anorganische Isolierschicht (106) und einen unteren Abschnitt der ersten organischen Isolierschicht (107) definiert ist, und
an einer Grenze zwischen dem ersten Abschnitt (hp1) und dem zweiten Abschnitt (hp2) der erste Abschnitt (hp1) eine erste Breite (w1) und der zweite Abschnitt (hp2) eine zweite Breite (w2), die in der Draufsicht kleiner ist als die erste Breite (w1), aufweist.

13. Verfahren zur Herstellung einer Anzeigevorrichtung (10), wobei das Verfahren Folgendes umfasst:
Bilden eines Transistors auf einem Substrat (100), der eine Halbleiterschicht (220), eine Gate-Elektrode (230), die in der Draufsicht die Halbleiterschicht (220) überlappt, und eine Source-Drain-Elektrode (320) umfasst;
aufeinanderfolgendes Bilden einer ersten anorganischen Isolierschicht (106) und einer ersten organischen Isolierschicht (107) auf dem Transistor und Bilden eines vorläufigen Kontaktlochs (pCNT1) durch Entfernen eines ersten Abschnitts der ersten anorganischen Isolierschicht (106) und eines Abschnitts der ersten organischen Isolierschicht (107);
Bilden einer Stromleitung (610) auf der ersten organischen Isolierschicht (107), die eine erste Schutzschicht (151), die ein anorganisches Isoliermaterial umfasst, eine erste leitfähige Schicht (611), die über der ersten Schutzschicht (151) angeordnet ist, und eine zweite leitfähige Schicht (613), die über der ersten leitfähigen Schicht (611) angeordnet ist, umfasst;
aufeinanderfolgendes Bilden einer zweiten anorganischen Isolierschicht (108) und einer zweiten organischen Isolierschicht (109) auf der Stromleitung (610);
Bilden eines ersten Kontaktlochs (CNT1) durch Entfernen eines zweiten Abschnitts der ersten anorganischen Isolierschicht (106), eines Abschnitts der zweiten anorganischen Isolierschicht (108) und eines Abschnitts der zweiten organischen Isolierschicht (109); und
Bilden einer Leuchtdiode auf der zweiten organischen Isolierschicht (109), die eine Pixelelektrode (510), eine Gegenelektrode (530) und eine zwischen der Pixelelektrode (510) und der Gegenelektrode (530) angeordnete Zwischenschicht (520) umfasst,
wobei das vorläufige Kontaktloch (pCNT1) so ausgebildet ist, dass es die zweite Source -Drain-Elektrode (320) in der Draufsicht überlappt,
wobei der zweite Abschnitt der ersten anorganischen Isolierschicht (106), der Abschnitt der zweiten anorganischen Isolierschicht (108) und der Abschnitt der zweiten organischen Isolierschicht (109) das vorläufige Kontaktloch (pCNT1) in der Draufsicht überlappen.

14. Verfahren nach Anspruch 13, wobei das Bilden des vorläufigen Kontaktlochs (pCNT1) Folgendes umfasst:
Bilden eines vorläufigen Unterlochs (107hp), das die erste organische Isolierschicht (107) durchdringt; und
Bilden einer Nut (106GR) durch Entfernen des ersten Abschnitts der ersten anorganischen Isolierschicht (106) durch das vorläufige Unterloch (107hp).

## Revendications

1. Appareil d'affichage (10) comportant :
un transistor disposé au-dessus d'un substrat (100) et comportant une couche semi-conductrice (220), une électrode de grille (230) chevauchant la couche semi-conductrice (220), et une électrode source-drain (320) ;
une première couche isolante inorganique (106) disposée au-dessus du transistor ;
une première couche isolante organique (107) disposée au-dessus de la première couche isolante inorganique (106) ;
une ligne d'alimentation (610) disposée au-dessus de la première couche isolante organique (107) et comportant une première couche conductrice (611) et une deuxième couche conductrice (613) sur la première couche conductrice (611) ;
une première couche protectrice (151) comportant un matériau isolant inorganique, disposée entre la première couche isolante organique (107) et la ligne d'alimentation (610) et présentant une forme correspondant à une forme de la ligne d'alimentation (610) dans une vue en plan ;
une deuxième couche isolante inorganique (108) disposée au-dessus de la ligne d'alimentation (610) ;
une deuxième couche isolante organique (109) disposée au-dessus de la deuxième couche isolante inorganique (108) ; et
une diode électroluminescente disposée au-dessus de la deuxième couche isolante organique (109) et comportant une électrode de pixel (510), une électrode opposée (530), et une couche intermédiaire (520) disposée entre l'électrode de pixel (510) et l'électrode opposée (530),
dans lequel la deuxième couche isolante inorganique (108) entre directement en contact avec la première couche protectrice (151), et la ligne d'alimentation (610) est séparée de la première couche isolante organique (107) et de la deuxième couche isolante organique (109) par la première couche protectrice (151) et la deuxième couche isolante inorganique (108).

2. Appareil d'affichage (10) selon la revendication 1, dans lequel l'électrode de pixel (510) est connectée électriquement à l'électrode de source-drain (320) à travers un premier trou de contact (CNT1),
le premier trou de contact (CNT1) comporte une première partie (hp1), qui est définie par la deuxième couche isolante organique (109), la deuxième couche isolante inorganique (108), et une partie supérieure de la première couche isolante organique (107), et une deuxième partie (hp2), qui est définie par la première couche isolante inorganique (106) et une partie inférieure de la première couche isolante organique (107), et
au niveau d'une limite entre la première partie (hp1) et la deuxième partie (hp2), la première partie (hp1) présente une première largeur (w1), et la deuxième partie (hp2) présente une deuxième largeur (w2) inférieure à la première largeur (w1) dans la vue en plan.

3. Appareil d'affichage (10) selon la revendication 2, dans lequel la limite entre la première partie (hp1) et la deuxième partie (hp2) est située entre une surface supérieure (107us) et une surface inférieure (170bs) de la première couche isolante organique (107).

4. Appareil d'affichage (10) selon l'une quelconque des revendications 1 à 3, comportant en outre :
une pastille (PAD) comportant une quatrième couche conductrice (621), une cinquième couche conductrice (623), et une sixième couche conductrice (625), qui sont empilées séquentiellement entre la première couche isolante organique (107) et la deuxième couche isolante inorganique (108) ; et
une deuxième couche protectrice (153) disposée entre la première couche isolante organique (107) et la pastille (PAD) et présentant une forme correspondant à une forme de la pastille (PAD) dans la vue en plan,
dans lequel la sixième couche conductrice (625) comporte de l'oxyde métallique.

5. Appareil d'affichage (10) selon l'une quelconque des revendications 1 à 4, comportant en outre une ouverture de pastille définie par la deuxième couche isolante inorganique (108) et la deuxième couche isolante organique (109) et chevauchant la pastille (PAD) dans la vue en plan.

6. Appareil d'affichage (10) selon la revendication 4 ou 5, dans lequel la ligne d'alimentation (610) comporte en outre une troisième couche conductrice (615) disposée entre la deuxième couche conductrice (613) et la deuxième couche isolante inorganique (108), et
la sixième couche conductrice (625) comporte un même matériau que la troisième couche conductrice (615).

7. Appareil d'affichage (10) selon l'une quelconque des revendications 1 à 6, comportant en outre :
une pastille (PAD) disposé entre le substrat (100) et la première couche isolante inorganique (106) et comportant une quatrième couche conductrice (621), une cinquième couche conductrice (623), et une sixième couche conductrice (625), qui sont empilées séquentiellement ; et
une ouverture de pastille définie par la première couche isolante inorganique (106) et la première couche isolante organique (107) et chevauchant la pastille (PAD) dans la vue en plan,
dans lequel la sixième couche conductrice (625) comporte de l'oxyde métallique.

8. Appareil d'affichage (10) selon la revendication 7, dans lequel l'électrode source-drain (320) comporte une première sous-couche (311), une deuxième sous-couche (313) et une troisième sous-couche (321), qui sont empilées séquentiellement, et
la sixième couche conductrice (625) comporte un même matériau que la troisième sous-couche (321).

9. Appareil d'affichage (10) comportant :
un transistor disposé au-dessus d'un substrat (100) et comportant une couche semi-conductrice (220), une électrode de grille (230) chevauchant la couche semi-conductrice (220) dans une vue en plan, et une électrode source-drain (320) ;
une première couche isolante inorganique (106) disposée au-dessus du transistor ;
une première couche isolante organique (107) disposée au-dessus de la première couche isolante inorganique (106) ;
une ligne d'alimentation (610) comportant une première couche de molybdène-titane (MoTi) (612) disposée au-dessus de la première couche isolante organique (107) et une deuxième couche conductrice (613) disposée au-dessus de la première couche de molybdène-titane (MoTi) (612) ;
une deuxième couche isolante inorganique (108) disposée au-dessus de la ligne d'alimentation (610) ;
une deuxième couche isolante organique (109) disposée au-dessus de la deuxième couche isolante inorganique (108) ; et
une diode électroluminescente disposée au-dessus de la deuxième couche isolante organique (109) et comportant une électrode de pixel (510), une électrode opposée (530), et une couche intermédiaire (520) disposée entre l'électrode de pixel (510) et l'électrode opposée (530),
dans lequel la deuxième couche isolante inorganique (108) entre directement en contact avec la première couche de molybdène-titane (MoTi) (612), et la deuxième couche conductrice (613) est séparée de la première couche isolante organique (107) et de la deuxième couche isolante organique (109) par la première couche (612) de molybdène-titane (MoTi) et la deuxième couche isolante inorganique (108).

10. Appareil d'affichage (10) selon la revendication 9, dans lequel, dans la vue en plan, une forme de la première couche de molybdène-titane (MoTi) (612) correspond à une forme de la deuxième couche conductrice (613), et
la deuxième couche isolante inorganique (108) entre en contact avec la première couche de molybdène-titane (MoTi) (612).

11. Appareil d'affichage (10) selon la revendication 9, comportant en outre :
une pastille (PAD) comportant une deuxième couche de molybdène-titane (622), une cinquième couche conductrice (623), et une sixième couche conductrice (625), qui sont empilées séquentiellement entre la première couche isolante organique (107) et la deuxième couche isolante inorganique (108),
dans lequel la sixième couche conductrice (625) comporte de l'oxyde métallique.

12. Appareil d'affichage (10) selon la revendication 9, dans lequel l'électrode de pixel (510) est connectée électriquement à l'au moins une électrode de source-drain (310, 320) à travers un premier trou de contact (CNT1),
le premier trou de contact (CNT1) comporte une première partie (hp1), qui est définie par la deuxième couche isolante organique (109), la deuxième couche isolante inorganique (108), et une partie supérieure de la première couche isolante organique (107), et une deuxième partie (hp2), qui est définie par la première couche isolante inorganique (106) et une partie inférieure de la première couche isolante organique (107), et
au niveau d'une limite entre la première partie (hp1) et la deuxième partie (hp2), la première partie (hp1) présente une première largeur (w1), et la deuxième partie (hp2) présente une deuxième largeur (w2) inférieure à la première largeur (w1) dans la vue en plan.

13. Procédé de fabrication d'un appareil d'affichage (10), le procédé comportant :
la formation, sur un substrat (100), d'un transistor comportant une couche semi-conductrice (220), une électrode de grille (230) chevauchant la couche semi-conductrice (220) dans une vue en plan, et une électrode source-drain (320) ;
la formation séquentielle, sur le transistor, d'une première couche isolante inorganique (106) et d'une première couche isolante organique (107) et la formation d'un trou de contact précédent (pCNT1) par le retrait d'une première partie de la première couche isolante inorganique (106) et d'une partie de la première couche isolante organique (107) ;
la formation, sur la première couche isolante organique (107), d'une ligne d'alimentation (610) comportant une première couche protectrice (151) comportant un matériau isolant inorganique, une première couche conductrice (611) disposée au-dessus de la première couche protectrice (151), et une deuxième couche conductrice (613) disposée au-dessus de la première couche conductrice (611) ;
la formation séquentielle, sur la ligne d'alimentation (610), d'une deuxième couche isolante inorganique (108) et d'une deuxième couche isolante organique (109) ;
la formation d'un premier trou de contact (CNT1) par le retrait d'une deuxième partie de la première couche isolante inorganique (106), d'une partie de la deuxième couche isolante inorganique (108), et d'une partie de la deuxième couche isolante organique (109) ; et
la formation, sur la deuxième couche isolante organique (109), d'une diode électroluminescente comportant une électrode de pixel (510), une électrode opposée (530), et une couche intermédiaire (520) disposée entre l'électrode de pixel (510) et l'électrode opposée (530),
dans lequel le trou de contact précédent (pCNT1) est formé pour chevaucher la deuxième électrode source-drain (320) dans une vue en plan,
dans lequel la deuxième partie de la première couche isolante inorganique (106), la partie de la deuxième couche isolante inorganique (108), et la partie de la deuxième couche isolante organique (109) chevauchent le trou de contact précédent (pCNT1) dans la vue en plan.

14. Procédé selon la revendication 13, dans lequel la formation du trou de contact précédent (pCNT1) comporte :
la formation d'un sous-trou précédent (107hp) pénétrant dans la première couche isolante organique (107) ; et
la formation d'une rainure (106GR) par le retrait de la première partie de la première couche isolante inorganique (106) à travers le sous-trou précédent (107ch).
